(19) Europäisches Patentamt
European Patent Office
Office européen des brevets

(11) EP 3 013 537 B2

(12) # NEUE EUROPÄISCHE PATENTSCHRIFT
Nach dem Einspruchsverfahren

(45) Veröffentlichungstag und Bekanntmachung des Hinweises auf die Entscheidung über den Einspruch:
**19.02.2020 Patentblatt 2020/08**

(45) Hinweis auf die Patenterteilung:
**12.10.2016 Patentblatt 2016/41**

(21) Anmeldenummer: **15736391.2**

(22) Anmeldetag: **15.05.2015**

(51) Int Cl.:
***B25J 9/16*** *(2006.01)*

(86) Internationale Anmeldenummer:
**PCT/DE2015/200313**

(87) Internationale Veröffentlichungsnummer:
**WO 2015/185049 (10.12.2015 Gazette 2015/49)**

(54) **VERFAHREN UND SYSTEM ZUR PROGRAMMIERUNG EINES ROBOTERS**
METHOD AND SYSTEM FOR PROGRAMMING A ROBOT
PROCÉDÉ ET SYSTÈME DE PROGRAMMATION D'UN ROBOT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.06.2014 DE 102014210525**
**13.03.2015 DE 102015204641**

(43) Veröffentlichungstag der Anmeldung:
**04.05.2016 Patentblatt 2016/18**

(73) Patentinhaber: **ArtiMinds Robotics GmbH**
**76131 Karlsruhe (DE)**

(72) Erfinder:
- **JAEKEL, Rainer**
  **71638 Ludwigsburg (DE)**
- **DIRSCHL, Gerhard**
  **74238 Krautheim (DE)**

(74) Vertreter: **Patent- und Rechtsanwälte Ullrich & Naumann**
**PartG mbB**
**Schneidmühlstrasse 21**
**69115 Heidelberg (DE)**

(56) Entgegenhaltungen:
**EP-A1- 1 724 676**
**WO-A1-2007/009511**
**DE-A1-102010 012 598**

- **CHU H ET AL: "INTEGRATION OF TASK PLANNING AND MOTION CONTROL IN A MULTI-ROBOT ASSEMBLY WORKCELL", ROBOTICS AND COMPUTER INTEGRATED MANUFACTURING, ELSEVIER SCIENCE PUBLISHERS BV., BARKING, GB, Bd. 10, Nr. 3, 1. Juni 1993 (1993-06-01), Seiten 235-255, XP000363219, ISSN: 0736-5845, DOI: 10.1016/0736-5845(93)90058-R**
- **PANG C CHEN ET AL: "GENERATING NATURAL-LANGUAGE LIKE ROBOT MOTION COMMAND SET THROUGH MACHINE LEARNING", PROCEEDINGS OF THE INTERNATIONAL CONFERENCE ON SYSTEMS, MAN, AND CYBERNETICS. SAN ANTONIO, OCT. 2 - 5, 1994; [PROCEEDINGS OF THE INTERNATIONAL CONFERENCE ON SYSTEMS, MAN, AND CYBERNETICS], NEW YORK, IEEE, US, Bd. 1 OF 03, 2. Oktober 1994 (1994-10-02), Seiten 114-119, XP000530678, ISBN: 978-0-7803-2130-4**

EP 3 013 537 B2

## Beschreibung

Die Erfindung betrifft ein Verfahren und ein System zur Programmierung eines Roboters, insbesondere eines Roboters umfassend einen Roboterarm.

Verfahren und Systeme der in Rede stehenden Art sind seit Jahren aus der Praxis bekannt. Demnach existieren für die Programmierung von Industrierobotern verschiedene Programmierverfahren: Teach-In, Playback, sensorgestützte Programmierung, CAD (Computer-aided design) Programmierung und dialoggestützte bzw. textuelle Programmierung.

Beim dem aus der Praxis bekannten Teach-In wird der Roboter durch das manuelle Anfahren und Abspeichern verschiedener Wegpunkte programmiert. Das Werkzeug dazu ist das Teach-Panel, eine Fernsteuerung mit grafischem Display auf dem der Roboterzustand und das Roboterprogramm dargestellt werden können. Der Benutzer fährt den Roboter an verschiedene Punkte, indem er zum Beispiel mit einem Joystick den Tool-Center-Point (TCP), einen definierten Punkt am letzten Gelenk des Roboters in 3 oder 6 Raumrichtungen, steuert. Der Benutzer speichert die Koordinaten der verschiedenen angefahrenen Punkte ab und integriert diese Information in das Roboterprogramm. Dabei wird jeder Wegpunkt als Ziel oder Zwischenpunkt eines Bewegungsbefehls definiert, zum Beispiel einer Punkt-zu-Punkt-, Linear- oder Zirkularbewegung. Der Bediener gibt zusätzliche Bahnparameter manuell ein, zum Beispiel Geschwindigkeit, Beschleunigung oder Überschleifen mit dem nächsten Befehl. Der Aufbau des Roboterprogramms, d.h. insbesondere die einzelnen Bewegungsbefehle, können üblicherweise aus einer Liste ausgewählt und zusammengestellt werden.

Beim dem aus der Praxis bekannten Playback werden nicht nur einzelne Punkte abgespeichert, sondern der Benutzer kann einen Roboterarm auf einer kontinuierlichen Bahn bewegen, wobei eine große Menge an Wegpunkten abgespeichert wird. Dadurch können komplexe Freiformbahnen, zum Beispiel entlang eines Kotflügels eines Fahrzeugs, einfach einprogrammiert werden, die durch einzelne Bewegungsbefehle beim Teach-In nur schwer programmiert werden könnten. Das kontinuierliche Führen wird üblicherweise durch einen Kraft-Momenten-Sensor (KMS) am Roboterflansch ermöglicht: der Mensch bzw. eine Bedienperson greift den Roboter und übt Kraft auf diesen aus. Die Kräfte werden mit dem KMS gemessen und an die Robotersteuerung übergeben, die fortlaufend eine Bewegung berechnet, die die Kräfte ausgleicht. Diese Bahn wird dann einem oder mehreren Bewegungsbefehlen im Roboterprogramm zugewiesen.

Bei der sensorgestützten Programmierung wird analog zum Playback eine kontinuierliche Bahn erzeugt, wozu jedoch weitere Sensoren eingesetzt werden. Zum Beispiel die Projektion einer Laserlinie auf ein Bauteil, die Erfassung dieser Linie mit einem Kamerasystem und Umrechnung der erkannten Linie in eine Bewegungsbahn für den Roboter. Dabei kann eine hohe Genauigkeit erzielt werden. Der Roboter muss nicht direkt bewegt werden, was bei großen Robotern von Vorteil ist. Jedoch ist zusätzliche Hardware sowie eine Kalibrierung von Kamera und Roboter notwendig.

Im Gegensatz zu diesen zuvor genannten Online-Verfahren, bei denen der Roboter direkt am Einsatzort programmiert wird, wird bei der CAD-Programmierung ein detailliertes CAD-Modell der Arbeitszelle, des Roboters und der zu manipulierenden Bauteile verwendet, um den Roboter in einer Simulationsumgebung zu programmieren. Dabei werden Wegpunkte durch Mausinteraktion, zum Beispiel auf der Oberfläche des CAD-Modells des Bauteils, festgelegt. Oder es werden komplette Bahnen auf der Oberfläche berechnet, zum Beispiel den Kanten des CAD-Modells oder einem bestimmten Muster, zum Beispiel Mäander, folgend. Die Punkte werden auf Punkt-zu-Punkt, Linear- oder Zirkularbewegungsbefehle abgebildet und als Roboterprogramm gespeichert. Analog zum Teach-In-Verfahren können zusätzliche Bahnparameter vorgegeben werden. Vorteile sind der geringe Aufwand zur Bestimmung einer Bahn entlang der Oberfläche von Objekten, da diese direkt anhand des CAD-Modells berechnet werden kann und die Nicht-Belegung des Roboters bei der Programmierung. Nachteilig sind jedoch die Kalibrierung zwischen realer Arbeitszelle und Simulation, die Bereitstellung von CAD-Modellen und die notwendige Anpassung bei kleinen Abweichungen.

Gemeinsamer Nenner der genannten Programmierverfahren ist die Programmierung mittels Wegpunkten und Sequenzen von Wegpunkten (Bahnen), die anschaulich mittels verschiedener Techniken erzeugt werden können. Ein wesentlicher Nachteil einzelner Wegpunkte, insbesondere kartesischer Wegpunkte, ist, dass diese zum Beispiel aufgrund von Hindernissen, Singularitäten und/oder mangelnder Erreichbarkeit bei kleinen Abweichungen nicht angefahren werden können und das Roboterprogramm damit fehlschlägt.

Bei der aus der Praxis bekannten dialoggestützten und textuellen Programmierung werden komplette Roboterprogramme mit Hilfe eines textuellen Editors oder eines grafischen Baukastens erstellt. Dabei kann der volle Leistungsumfang der Robotersteuerung ausgenutzt werden. Insbesondere kann durch die Auswertung von roboterexternen Sensoren auf Prozessabweichungen reagiert werden, die zum Beispiel durch die visuelle Lokalisierung eines zu manipulierenden Bauteils oder Fertigungstoleranzen entstehen. Mittels der direkten Programmierung in der Roboterprogrammiersprache können zusätzliche Bewegungsbefehle genutzt werden, die aktuell nicht mittels oben genannter Techniken programmiert werden können, zum Beispiel eine Kraftsteuerung mittels FTCtrl von KUKA oder AdeptForce von Adept. Für die Kraftsteuerung können zum Beispiel die Raumrichtungen für die Regelung, Sollwerte für Kraft/Moment und einfache Abbruchbedingungen vorgegeben werden. Aus diesen grundlegenden Befehlen können sehr komplexe Roboterprogramme erstellt werden. Dabei bestehen selbst einfache Aufgaben, wie zum Beispiel das Einsetzen eines Zylinders in ein Loch, aus mehreren Bewegungsbefehlen und unterschiedlichen Kraftreglern. Eine durchschnittliche Montageaufgabe basiert auf einer Vielfalt solcher Aufgaben, zum Beispiel Einsetzen, Verschrauben, Einhaken. Daher ist die Umsetzung einer Montageaufgabe mit sehr hohem Aufwand verbunden. Des Weiteren ist nachteilig, dass Expertenwissen betreffend einer Roboterprogrammiersprache, des Prozesses und des Roboters notwendig sind.

Weiter problematisch ist, dass der Automatisierungsgrad heutzutage in der Industrie, selbst im Automobilbereich, relativ gering ist. Der überwiegende Teil der Anwendungen, die unter Verwendung von Roboterarmen automatisiert werden, können durch das Abfahren von fest programmierten Bewegungsbahnen, ohne die sensorbasierte Reaktion auf Abweichungen, charakterisiert werden. Dabei wird ein Werkzeug, zum Beispiel eine Schweißzange, auf der fest programmierten Bewegungsbahn bewegt. Durch einen hohen und teuren Engineeringaufwand werden die Abweichungen im Prozess auf ein vernachlässigbares Maß reduziert, zum Beispiel durch spezielle Greifer für jedes Bauteil und spezielle, hochgenaue Zuführungseinrichtungen. Erst dadurch kann ggf. eine Programmierung mittels Teach-In oder Playback zur Erzeugung der festen Bewegungsbahn eingesetzt werden. Falls dies ökonomisch nicht möglich ist, wird in den meisten Fällen von einer Automatisierung mittels komplexerer Programmierung abgesehen. Problematisch bei diesem Vorgehen ist, dass dieser Ansatz schnell an seine Grenzen stößt, zum Beispiel auf Grund folgender Probleme:

- Kleinserien erfordern eine häufige Umprogrammierung, wodurch der hohe Engineeringaufwand unökonomisch ist. Beispielsweise können in der Qualitätssicherung Prüfungen an im Wochentakt sich ändernden Geräten erforderlich sein, zum Beispiel Waschmaschinenlangzeittests.
- Montageaufgaben besitzen oft geringes Spiel, wodurch eine Kraftinteraktion, zum Beispiel beim Stecken von Bauteilen, unumgänglich ist, und bestehen aus einer Vielzahl an unterschiedlichen Teilaufgaben, wie zum Beispiel Greifen, Fügen, Kontaktieren.
- Nachgiebige Bauteile besitzen Abweichungen in der Geometrie, die im Prozess berücksichtigt werden müssen, zum Beispiel ein nachgebendes Blech beim Greifen oder das Fügen von Plastikteilen.
- Mittels visueller Sensoren erkannte Objekte, zum Beispiel eine Schraube zum Verschrauben, befinden sich an immer unterschiedlichen Raumpunkten, weshalb die Positionierung des Roboters flexibel sein muss

Deshalb werden solche Aufgaben, die nicht mit festen Bewegungsbahnen programmiert werden können, zum Beispiel in der Montage und Qualitätssicherung, heutzutage größtenteils durch Menschen durchgeführt.

Des Weiteren ist aus der H. CHU et al.: "INTEGRATION OF TASK PLANNING AND MOTION CONTROL IN A MULTI-ROBOT ASSEMBLY WORKCELL", ROBOTICS AND COMPUTER INTEGRATED MANUFACTURING, Bd. 10, Nr. 3, 1. Juni 1993 (1993-06-01), Seiten 235-255, XP000363219 ein Verfahren zur Programmierung eines Roboters bekannt, wobei dieses Dokument die Integration einer Aufgabenplanung und Bewegungssteuerung in einer Multi-Roboter-Montagezelle betrifft.

Der vorliegenden Erfindung liegt daher die Aufgabe zugrunde, ein Verfahren und ein System zur Programmierung eines Roboters der eingangs genannten Art derart auszugestalten und weiterzubilden, dass eine einfache und robuste Programmierung des Roboters, insbesondere für einen Manipulator- und/oder einen Montageprozess, ermöglicht ist.

Erfindungsgemäß ist die voranstehende Aufgabe durch die Merkmale des Patentanspruchs 1 gelöst.

Des Weiteren ist die voranstehende Aufgabe durch die Merkmale des Patentanspruchs 11 gelöst.

Schließlich ist die voranstehende Aufgabe durch die Merkmale des Patentanspruchs 12 betreffend ein Computerprogrammprodukt gelöst.

In erfindungsgemäßer Weise ist zunächst einmal erkannt worden, dass die Erstellung von Roboterprogrammen, die tolerant gegenüber Abweichungen in der Positionierung und Geometrie von Objekten sind, verglichen mit der dialoggestützten und textuellen Programmierung wesentlich zu vereinfachen ist, um zuvor genannte Aufgaben oder Probleme für die Automatisierung - und ggf. die damit verbundenen Vorteile wie Durchsatz, Wiederholbarkeit, Qualität, etc. - möglichst effizient erschließen zu können. Durch im Roboterprogramm realisierte Toleranz gegenüber Abweichungen kann der allgemeine Engineeringaufwand erheblich verringert werden, zum Beispiel durch einfache, standardisierte, vorzugsweise auch für Menschen geeignete, Zuführungseinrichtungen und Greifersysteme, damit eine Automatisierung ökonomisch erfolgt.

Erfindungsgemäß wird zur Programmierung eines Roboters, insbesondere eines Roboters umfassend einen Roboterarm, eine auszuführende Roboterbewegung über eine vordefinierte Bewegungsschablone, vorzugsweise in einem Roboterprogramm, eingerichtet. Die Bewegungsschablone wird aus einer mehrere Bewegungsschablonen umfassenden Datenbank selektiert, wobei die Bewegungsschablone erfindungsgemäß ein oder mehrere parametrierbare Ausführungsmodule und mindestens ein Lernmodul umfasst. Das Ausführungsmodul bzw. die Ausführungsmodule wird/werden zur Planung und/oder Durchführung der Roboterbewegung bzw. einer Teilbewegung der Roboterbewegung verwendet. Das Lernmodul zeichnet in einem Initialisierungsprozess, zum Beispiel in Form eines Teach-Prozesses, mehrere Konfigurationen des Roboters auf. Basierend auf den aufgezeichneten Konfigurationen berechnet das Lernmodul, unter Verwendung eines maschinellen Lernverfahrens wie beispielsweise der RANSAC-Algorithmus oder die Hauptkomponentenanalyse, Parameter für das Ausführungsmodul bzw. für die Ausführungsmodule.

Der Nachteil der klassischen Programmierverfahren Teach-In und Playback ist, dass nur Wegpunkte und Bahnen erzeugt werden können, jedoch keine Informationen ob oder wie diese Wegpunkte oder Bahnen angepasst werden müssten, um Abweichungen tolerieren bzw. kompensieren zu können. Im Unterschied zu Ansätzen zur Berücksichtigung von Abweichungen bei der Ausführung von Bewegungsbahnen durch die Vorgabe von Bewegungskorridoren kann mit dem erfindungsgemäßen Verfahren bzw. dem erfindungsgemäßen System berücksichtigt werden, dass sich nicht nur Abweichungen bei der Bewegungsbahn ergeben, sondern beispielsweise auch bei der zeitlichen Änderung der Greiferstellungen und/oder der gemessenen Kräfte und in verschiedenen Prozessschritten unterschiedliche Abweichungen zu berücksichtigen sind.

Folglich ist mit dem erfindungsgemäßen Verfahren und mit dem erfindungsgemäßen System sowie mit dem erfindungsgemäßen Computerprogrammprodukt eine einfache und robuste Programmierung eines Roboters, insbesondere für einen Manipulator- und/oder einen Montageprozess, ermöglicht.

Erfindungsgemäß können die Parameter des Ausführungsmoduls bzw. der Ausführungsmodule Bedingungen umfassen, wobei auf Basis der Bedingungen die Roboterbewegung bzw. die Teilbewegung der Roboterbewegung geplant und/oder durchgeführt wird. Somit kann eine variable und dynamische Planung einer Roboterbewegung bzw. einer Teilbewegung einer Roboterbewegung erfolgen, so dass eine möglichst robuste und flexible Durchführung der Roboterbewegung realisierbar ist, insbesondere hinsichtlich etwaiger Abweichungen betreffend die Bewegung.

Erfindungsgemäß kann eine Bedingung eine Bedingungsfunktion f und eine Bedingungsregion R umfassen, wobei die Bedingungsfunktion f eine Konfiguration k in einen vorzugsweise reellwertigen Vektorraum abbildet, und wobei die Bedingungsregion R einer Teilmenge eines, vorzugsweise reellwertigen, Vektorraums entspricht. Eine Bedingung für eine Konfiguration k ist erfüllt, wenn f(k) in R liegt. Somit ist auf raffinierte Weise eine einheitliche Umsetzung verschiedenster Bedingungen möglich, was eine effektive Bahn- und Bewegungsplanung des Roboters ermöglicht.

Des Weiteren kann als Typ für eine Bedingungsfunktion f einer oder mehrere der folgenden Typen verwendet werden:

- Gelenkwinkel, -geschwindigkeit und/oder -beschleunigung des Roboters oder eines Endeffektors, insbesondere eines Greifers, des Roboters;
- Position, Orientierung und/oder Lage eines Tool-Center-Points des Roboters relativ zu einem Koordinatensystem;
- Geschwindigkeit, Winkelgeschwindigkeit und/oder Twist gemessen in einem Tool-Center-Point relativ zu einem Koordinatensystem;
- Kraft, Drehmoment und/oder Wrench gemessen in einem Tool-Center-Point relativ zu einem Koordinatensystem;
- Kollisionsfreiheit, Distanzbetrag und/oder Distanzvektor von einem CAD-Modell zu einem weiteren CAD-Modell;
- Griffbewertung von einem Endeffektor, insbesondere eines Greifers, des Roboters und einem CAD-Modell.

Somit kann durch Verwendung eines oder durch Kombination mehrerer der zuvor genannten Typen im Rahmen einer oder mehrerer Bedingungsfunktionen eine möglichst umfassende Berücksichtigung und Kompensierung von diversen Abweichungen in der Planung und Durchführung der Roboterbewegung erfolgen bzw. bereitgestellt werden.

Erfindungsgemäß kann als Typ für eine Bedingungsregion R ein achsausgerichteter Würfel, ein orientierter Würfel, ein Zylinder, ein Kegel, eine Kugel, eine Konvexe Hülle, ein CAD-Modell, eine Veroderung, eine Verundung und/oder eine Produktbildung verwendet werden. Die Veroderung, Verundung und Produktbildung kombinieren mindestens zwei Bedingungsregionen zu einer einzelnen Bedingungsregion. Somit können je nach Anwendungsfall und Typ einer Bedingungsfunktion der geeignete Wertebereich - durch entsprechende Verwendung des passenden Typs für die dazugehörige Bedingungsregion - gewählt werden.

In vorteilhafter Weise können die Parameter des Ausführungsmoduls bzw. der Ausführungsmodule Währendbedingungen als Bedingungen umfassen, wobei eine Währendbedingung eine zeitabhängige Bedingung ist, die für ein vorgebbares Intervall von Zeitpunkten eine zu erfüllende Bedingung definiert.

Des Weiteren können die Parameter des Ausführungsmoduls bzw. der Ausführungsmodule Zielbedingungen als Bedingungen umfassen, wobei eine Zielbedingung eine Bedingung ist, die für eine obere Intervallgrenze eines bzw. des vorgebbaren Intervalls von Zeitpunkten eine zu erfüllende Bedingung definiert.

Die Menge der Während- und Zielbedingungen einer bedingungsbasierten Bewegungsbeschreibung kann somit - direkt - zulässige Abweichungen modellieren, die während der Ausführung eines Manipulator- bzw. eines Montageprozesses auftreten können. Des Weiteren stellen Während- und Zielbedingungen Informationen dar, wie größere Abweichungen zu kompensieren sind. Dies stellt einen wesentlichen Fortschritt gegenüber klassischen Programmiermethoden dar, die keine derartige Information zur Verfügung stellen.

In einer vorteilhaften Ausgestaltung kann das Ausführungsmodul bzw. können die Ausführungsmodule unter Einhaltung eines Regelungsalgorithmus die Roboterbewegung oder eine Teilbewegung der Roboterbewegung derart adaptieren bzw. anpassen, dass die Währendbedingungen eingehalten werden. Des Weiteren kann bei Erfüllung der Zielbedingungen die Roboterbewegung bzw. eine Teilbewegung der Roboterbewegung erfolgreich beendet werden. Folglich führt ein Roboter eine Bewegung erfolgreich durch, wenn alle für die Bewegungsbahn gegebenen Während- und Zielbedingungen erfüllt sind. Der Roboter wird unter Einhaltung von Regelungsalgorithmen seine Bewegung so adaptieren, dass die Währendbedingungen eingehalten werden. Sobald die Zielbedingungen erfüllt sind, wird die Bewegung erfolgreich beendet. Ansonsten ist die Ausführung nicht erfolgreich.

In besonders vorteilhafter Weise kann basierend auf den Bedingungen, insbesondere basierend auf den Während- und/oder Zielbedingungen, für das Ausführungsmodul bzw. für die Ausführungsmodule der Bewegungsschablone, vorzugsweise unter Verwendung eines Bahnplanungsalgorithmus, eine Bewegungsbahn berechnet werden.

In vorteilhafter Weise kann das Ausführungsmodul bzw. die Ausführungsmodule mittels Kompilierung auf ein Zielsystem, zum Beispiel eine Robotersteuerung, abgebildet werden. Dazu kann basierend auf dem jeweiligen Regelungstyp, der berechneten Bewegungsbahn sowie den Während- und Zielbedingungen ausführbarer Robotercode erzeugt werden. Der Robotercode kann dann auf dem jeweiligen Zielsystem alleinständig ausgeführt werden.

Des Weiteren ist es denkbar, dass in dem Initialisierungsprozess die aufzuzeichnenden Konfigurationen mittels unterschiedlicher Schnittstellen durch einen Benutzer erzeugbar sind. Zum Beispiel mittels manuellen Führens des Roboters durch den Benutzer, mittels Mausinteraktion in einer 3D-Simulationsumgebung und/oder mittels weiterer geeigneter Steuermittel.

In einer vorteilhaften Ausgestaltung kann in dem Initialisierungsprozess eine Interaktion mit einem Benutzer durchgeführt werden, wobei Rückfragen bzw. Anweisungen an den Benutzer zur Erzeugung der aufzuzeichnenden Konfigurationen gestellt werden. Somit kann der Benutzer während des Initialisierungsprozesses bzw. beim Teach-Prozess effektiv unterstützt werden.

Im Hinblick auf eine einfache und effiziente Strukturierung kann das Ausführungsmodul bzw. können die Ausführungsmodule derart hierarchisch aufgebaut sein, dass ein Ausführungsmodul als nicht zerlegbarer primitiver Operator, d.h. als primitives Ausführungsmodul, ausgebildet ist oder aus einem oder mehreren Ausführungsmodulen und/oder einer oder mehreren Bewegungsschablonen zusammengesetzt ist. Somit können bereits vorhandene und ggf. parametrierte Bewegungsschablonen oder Ausführungsmodule effizient wiederverwendet werden.

Das erfindungsgemäße Verfahren ermöglicht eine robuste Einrichtung von Roboterprogrammen, die tolerant gegenüber Abweichungen in der Positionierung von Werkstücken und deren Geometrie sind, und ist industriell vorteilhaft einsetzbar.

Derartige Roboterprogramme werden nicht direkt in Form von Befehlen der Roboterprogrammiersprache (im Gegensatz zur dialoggestützten, textuellen Programmierung) erzeugt, sondern können auf Basis einer Datenbank von vordefinierten Bewegungsschablonen in einem Initialisierungsprozess bzw. Teach-Prozess erstellt werden. Die Bewegungsschablonen können, analog zum Teach-In, auf Basis von wenigen Konfigurationen für einen vorliegenden Prozess eingerichtet werden. Die Bewegungsschablonen umfassen vorzugsweise eine ausführbare Vorschrift, um Abweichungen im Prozess bei der Roboterausführung zu detektieren und ggf. zu kompensieren. Dabei können die bei Teach-In verwendeten Interpolationsverfahren zur Erzeugung von Bewegungsbahnen zwischen Wegpunkten durch Bahnplanungsverfahren ergänzt werden, die Bewegungsbahnen zwischen (implizit definierten) Wegpunktbereichen erzeugen können.

Nachfolgend werden einige Aspekte der Erfindung anhand einer beispielhaften Implementierung näher ausgeführt. Es sei darauf hingewiesen, dass die nachfolgenden Ausführungen lediglich besonders bevorzugte Ausführungsbeispiele beinhalten, die Lehre jedoch nicht als auf diese Ausführungsbeispiele beschränkt anzusehen sind.

Der Teach-Prozess als Initialisierungsprozess kann insbesondere die folgenden Schritte umfassen:

1. Hinzufügen einer Bewegungsschablone aus einer Datenbank in ein Roboterprogramm (bzw. in ein leeres Roboterprogramm), zum Beispiel Einfügen, Spiralsuche, Anrücken und Greifen, Kontaktieren. Für jede Bewegungsschablone kann je eine Menge von Ausführungsmodulen und ein Lernmodul gegeben sein. Jedes Ausführungsmodul enthält Parameter, vorzugsweise einschließlich Während- und Zielbedingungen. Ein primitives Ausführungsmodul kann dabei einem bestimmten Regelungsalgorithmus entsprechen, wobei bekannte Reglerimplementierungen, wie beispielsweise eine hybride Kraft-Positionsregelung, erweitert werden. Das Lernmodul implementiert maschinelle Lernverfahren um die Parameter aus geteachten Konfigurationen und/oder aus dialogbasierten Eingaben zu erstellen.

2. Das Lernmodul wird ausgeführt. Es kann als Erweiterung der Teach-In Programmierung, insbesondere auf die Erstellung von Während- und Zielbedingungen, aufgefasst werden. Das Lernmodul kann je nach Lernmodultyp Rückfragen (grafisch: 3D Visualisierung auf Robotersteuerung/externer PC, dialogbasiert: 2D Visualisierung) an den Benutzer bzw. an die Bedienperson zur Erzeugung bestimmter Konfigurationen stellen, wobei aus den Konfigurationen später die Parameter der Ausführungsmodule durch das Lernmodul berechnet werden. Der Benutzer erzeugt diese Konfigurationen mittels unterschiedlicher Schnittstellen, zum Beispiel durch Führen des realen Roboters oder durch Mausinteraktion in einer 3D-Simulationsumgebung. Zum Beispiel wird der reale Roboter in vier Konfigurationen bewegt, die vier Ecken eines Rechtecks markieren sollen oder der Benutzer markiert die entsprechenden vier Punkte auf einem CAD-Modell. Die Konfigurationen werden aufgezeichnet, zum Beispiel mittels der im Roboterarm integrierten Sensorik sowie externem Kraft-Momenten-Sensor (KMS).

3. Im Lernmodul einer Bewegungsschablone sind maschinelle Lernverfahren implementiert, die aus den aufgezeichneten Konfigurationen, welche Roboterarmstellung und/oder Greiferstellung und/oder Kraft/Momentemessungen und/oder Punkte auf einem CAD-Modell beinhalten können, die Parameter der Ausführungsmodule berechnen.

4. Basierend auf den Parametern kann für jedes Ausführungsmodul der Bewegungsschablone eine Bewegungsbahn berechnet werden, vorzugsweise unter Verwendung von Bahnplanungsalgorithmen, zum Beispiel Rapidly-Exploring-Random-Tree-Algorithmus. Dieser Schritt ist analog zum Teach-In, bei dem basierend auf Wegpunkten unter Auswahl von Interpolationsarten eine kontinuierliche Bahn, zum Beispiel eine lineare Verbindung zweier Wegpunkte erzeugt wird. Hier werden basierend auf Bedingungen, insbesondere Während- und Zielbedingungen, kontinuierliche Bahnen unter Einsatz von Planungsalgorithmen erzeugt.

5. Die Ausführungsmodule mit Parametern können auf ein Zielsystem, d.h. eine Robotersteuerung, zum Beispiel unter Einsatz von Kompilierung abgebildet werden. Dazu wird basierend auf dem jeweiligen Regelungstyp, der berechneten Bewegungsbahn sowie den Während- und Zielbedingungen ausführbarer Robotercode erzeugt. Der Robotercode kann dann auf dem jeweiligen Zielsystem alleinständig ausgeführt werden. In einer alternativen Umsetzung können die Ausführungsmodule, inbesondere die primitiven Ausführungsmodule, direkt auf einer Computer- bzw. PCbasierten Steuerung ohne Überführung in Robotercode ausgeführt werden.

Die Parameter der Ausführungsmodule müssen im Gegensatz zum klassischen Teach-In oder Playback keine Wegpunkte oder Bewegungsbahnen sein, sondern können Während- und Zielbedingungen darstellen, die beide einheitlich wie folgt definiert werden können:

Eine Bedingung besteht aus einer Bedingungsfunktion f (constraint function), die eine Konfiguration k in einen reellwertigen Vektorraum abbildet, und einer Bedingungsregion R (constraint region), die einer Teilmenge eines reellwertigen Vektorraums entspricht. Eine Bedingung ist für eine Konfiguration k erfüllt, genau dann wenn f(k) in R liegt.

Folgende Typen können zum Beispiel für eine Bedingungsfunktion f eingesetzt werden:

- Gelenkwinkel, -geschwindigkeit und/oder -beschleunigung des Roboters oder eines Endeffektors, insbesondere eines Greifers, des Roboters;
- Position, Orientierung und/oder Lage eines Tool-Center-Points des Roboters relativ zu einem Koordinatensystem;
- Geschwindigkeit, Winkelgeschwindigkeit und/oder Twist gemessen in einem Tool-Center-Point relativ zu einem Koordinatensystem;
- Kraft, Drehmoment und/oder Wrench gemessen in einem Tool-Center-Point relativ zu einem Koordinatensystem;
- Kollisionsfreiheit, Distanzbetrag und/oder Distanzvektor von einem CAD-Modell zu einem weiteren CAD-Modell;
- Griffbewertung von einem Endeffektor, insbesondere eines Greifers, des Roboters und einem CAD-Modell.

Im Hinblick auf eine Positions-, Orientierungs- oder Lagebedingungsfunktion (Pose constraint) stellt eine Bedingungsfunktion f die aktuelle Lage des Werkzeugpunkts (Tool Center Point TCP) relativ zu einem bestimmten (vordefinierten) Koordinatensystem K als 3-dimensionalen Vektor (Positions-, Orientierungsbedingung) oder als 6-dimensionalen Vektor (Lagebedingung) dar.

Im Rahmen einer beispielhaften Ausgestaltung kann die Berechnung der Lagebedingungsfunktion bestehend aus einem 3-dimensionalen Vektor der Position und einem 3-dimensionalen Vektor der Orientierung wie folgt beschrieben werden. Positions- und Orientierungsbedingungen bestehen nur aus dem jeweils 3-dimensionalen Vektor.

Wenn H die homogene Transformationsmatrix ist, die die Lage des TCPs relativ zu K beschreibt, dann wird der 6-dimensionale Vektor gebildet aus dem 3-dimensionalen Translationsvektor von H sowie der 3-dimensionalen skalierten Rotationsachse von H (axis-angle representation). Die skalierte Rotationsachse von H kann wie folgt berechnet werden:

1. die 3x3 Rotationsmatrix von H wird in ein Quaternion (qx, qy, qz, qw) umgewandelt, wobei qw der Realteil ist.
2. Der Rotationswinkel a ist 2 * acos(qw). Acos ist die Arkuskosinus-Funktion.
3. Die skalierte Rotationsachse ist a * 1 / sin(a) * [qx qy qz]. [qx qy qz] ist der 3-dimensionale Vektor bestehend aus qx, qy und qz.

Eine Geschwindigkeits-, Winkelgeschwindigkeits- sowie Twistbedingungsfunktion kann in analoger Weise berechnet werden (Twist = 6-dimensionaler Vektor bestehend aus 3-dimensionalen Geschwindigkeits- und 3-dimensionalen Winkelgeschwindigkeitsvektor). Allerdings wird hier die 3-dimensionale (Translations-) Geschwindigkeit und die 3-dimensionale Winkelgeschwindigkeit des TCPs relativ zu einem bestimmten Koordinatensystem K gemäß der Transformationsvorschrift für Geschwindigkeitsvektoren transformiert und als Wert der Bedingungsfunktion gespeichert.

Kraft-, Drehmoment- sowie Wrenchbedingungsfunktionen können ebenfalls analog wie im vorigen Abschnitt behandelt werden. Dabei wird die Kraft, das Drehmoment oder die Kombination aus Kraft und Drehmoment (Wrench) berechnet.

Gelenkwinkel, Gelenkgeschwindigkeit und Gelenkbeschleunigungsbedingungsfunktionen stellen direkt die n-dimensionalen Vektoren der aktuellen Position, Geschwindigkeit und Beschleunigung der Bewegungsfreiheitsgrade des Robotersystems dar.

Eine Kollisionsfreiheitsbedingungsfunktion kann derart implementiert sein, dass diese als Wert 1 ausgibt, falls eine Kollision der 3D CAD Modelle der Umgebung mit den 3D CAD Modellen des Roboters oder des Roboters mit sich selbst vorliegt. Diese Kollisionsberechnung kann u.a. durch Intersektion der Dreiecksnetze der 3D CAD Modelle erfolgen, wofür ggf. gängige Bibliotheken eingesetzt werden können. Falls keine Kollision vorliegt, wird 0 zurückgegeben.

Eine Distanzbetragsbedingungsfunktion berechnet vorzugsweise die euklidische Distanz eines 3D CAD Modells zu einem zweiten 3D CAD Modell als den Abstand des Punktpaares, welches aus den beiden Punkten des ersten und zweiten 3D Modells mit kürzestem Abstand zueinander entspricht. Eine Distanzvektorbedingungsfunktion berechnet vorzugsweise den normierten Vektor vom ersten zum zweiten Punkt des gleichen Punktpaares.

Eine Lagebedingung kann beispielsweise wie folgt realisiert bzw. implementiert werden: Sei das Koordinatensystem K im Schwerpunkt eines Objekts definiert. Dann wird die relative Lage des TCPs relativ zu K als 6-dimensionaler Vektor nach obiger Formel berechnet. R sei ein 6 dimensionaler Würfel gegeben als Mittelpunktsvektor [m1 m2 m3 m4 m5 m6] und Abweichungsvektor [e1 e2 e3 e4 e5 e6]. Der Würfel entspricht allen Vektoren [v1 v2 v3 v4 v5 v6] mit mi - ei <= vi <= mi + ei. Die Bedingung besagt, dass der Tool Center Point, und damit ebenfalls die Roboterarmstellung, in einem bestimmten Bereich liegen muss, zum Beispiel oberhalb des Objekts, das gegriffen werden soll. Das Koordinatensystem K ist in diesem Fall im Schwerpunkt des Objekts definiert. In diesem Fall wären mögliche Werte von R:

$$[m1\ m2\ m3\ m4\ m5\ m6] = [0\ 0\ 0.05\ 1.5708\ 0\ 0]$$

und

$$[e1\ e2\ e3\ e4\ e5\ e6] = [0.01\ 0.01\ 0\ 0\ 0\ 0].$$

Die Bedingungsregion befindet sich zu 0.05m oberhalb des Schwerpunkts des Objekts mit einer Orientierung von ca. 90 Grad, entsprechend 1.5708 rad, um die x-Achse rotiert. Erlaubte Abweichungen von diesem Punkt sind 0.01m in x- sowie in $\gamma$-Richtung.

Eine Kraftbedingung (force constraint) kann wie folgt realsiert werden: Die gemessene Kraft mit dem KMS wird als 3-dimensionaler Vektor [fx fy fz] dargestellt. Die Bedingungsregion R sei eine 3-dimensionale Kugel R mit Radius r und Mittelpunktsvektor [m1 m2 m3]. Die Kraftbedingung ist erfüllt, genau dann wenn [fx fy fz] in R liegt, d.h.

$$\text{norm}([fx\ -\ m1\ \ fy - m2\ \ fz - m3]) <= r.$$

Dabei ist norm die euklidische Norm des Vektors. Die Kraftbedingung ist somit erfüllt, genau dann wenn der Betrag der Kraft kleiner gleich r ist.

Im Rahmen eines bevorzugten Ausführungsbeispiels der Erfindung sollte bzw. muss eine Bedingungsfunktion eine oder mehrere der folgenden Berechnungen erfüllen, wobei K eine Konfiguration und r ein reellwertiger Vektor mit Dimension entsprechend der Dimension von R(k) ist:

1. f(k) = r, d.h. die Funktion f kann auf die Konfiguration k angewendet werden. Dies muss für alle Funktionen f erfüllt sein.
2. $f^{-1}$(r, k') = k, d.h. wenn ein Wert r und eine Referenzkonfiguration k' gegeben ist, kann eine Konfiguration k berechnet werden, die f(k) = r erfüllt. (Berechnung B.1)
3. f(k) kann mittels r inkrementiert werden, d.h. wenn eine Konfiguration k und ein Vektor r gegeben ist, dann kann eine Konfiguration k' berechnet werden, so dass f(k') = f($f^{-1}$(f(k) + r)), d.h. die Konfiguration k wird so abgeändert, dass die Änderung einem gegebenen Schritt r in R entspricht.

Gemäß einem Ausführungsbeispiel definiert eine Bedingungsregion einen reellwertigen Wertebereich R. R sollte bzw. muss dabei eine oder mehrere der folgenden Berechnungen erlauben. r sei ein reellwertiger Vektor mit Dimension gleich Dimension von R:

1. Reellwertige Distanz d >= 0 von r zu R: d ist 0, falls r in R ansonsten der minimale Abstand von r zur Oberfläche von R (Berechnung B.2)
2. Reellwertige Distanz d von r zur Oberfläche von R: falls r in R ist d der negative Wert des minimalen Abstands von r zur Oberfläche von R. Ansonsten ist d der minimale Abstand von r zur Oberfläche von R
3. Enthalten e = 0 oder 1. e ist 1, genau dann wenn r in R. Diese Berechnung muss von allen Bedingungsregionen erfüllt werden.
4. Den Mittelpunkt m von R. Diese Berechnung muss von allen Bedingungsregionen erfüllt werden.
5. Zufälliger Punkt auf Oberfläche r. Es kann ein zufälliger Vektor r berechnet werden, so dass r auf der Oberfläche von R liegt.
6. Zufälliger Punkt aus Innenraum. Es kann ein zufälliger Vektor r berechnet werden, so dass r in R liegt. (Berechnung B.3)
7. Berechnung der Ausdehnung von R in eine beliebige Richtung v. (Berechnung B.4)

Eingesetzte Typen von R können dabei sein: Achsausgerichteter Würfel (axisaligned bounding box), orientierter Würfel (oriented bounding box), Zylinder, Kegel, Kugel, Konvexe Hülle, CAD-Modell, Veroderung, Verundung und/oder Tupelbildung.

Die Menge der Während- und Zielbedingungen einer bedingungsbasierten Bewegungsbeschreibung kann somit direkt zulässige Abweichungen modellieren, die während der Ausführung eines Roboterprogramms, zum Beispiel eines Montageprozesses, auftreten können. Des Weiteren stellen sie Informationen dar, wie größere Abweichungen zu kompensieren sind, was einen wesentlichen Fortschritt gegenüber klassischen Programmiermethoden darstellt, die keine derartige Information zur Verfügung stellen.

Eine mögliche Kompensation größerer Abweichungen wird im Folgenden detaillierter beschrieben. Dabei wird zwischen Bewegungsplanung und Regelung unterschieden.

Im Rahmen einer Bewegungsplanung ist das Ziel die Erzeugung einer Bewegungsbahn, die eine bedingungsbasierte Bewegungsbeschreibung erfüllt. Hierbei kann der Algorithmus Constraint-based bidirectional Rapidly-Exploring Random Tree (CBiRRT) nach Berenson et al.: "Manipulation Planning on Gonstraint Manifolds", IEEE International Conference on Robotics and Automation (ICRA '09), May, 2009 mit der Projektionstechnik Randomized Gradient Descent (RGD) nach Stilman, M: "Task constrained motion planning in robot joint space," Intelligent Robots and Systems, 2007 kombiniert werden und auf die Während- und Zielbedingungen angepasst werden. Der Bahnplanungsalgorithmus umfasst dann folgende Schritte:

1. Erzeugung von Zielkonfigurationen, d.h. Konfigurationen, für die alle Zielbedingungen erfüllt sind. Da die Menge der Zielkonfigurationen im Allgemeinen mehr als ein Element enthält, handelt es sich hierbei um zulässige Abweichungen, zum Beispiel von einer Stelle, an der das Robotersystem einen Gegenstand ablegen kann.
2. Suche einer stückweise linearen Verbindung von einer Startkonfiguration zu den erzeugten Zielkonfigurationen. In diesem Schritt wird die Bewegungsbahn erzeugt, die von der Startkonfiguration zu einer der Zielkonfigurationen führt. Dadurch ist das Robotersystem in der Lage zielgerichtet innerhalb der zulässigen Abweichungen, die in Form von Währendbedingungen gegeben sind, eine gültige Bewegungsbahn autonom zu generieren.

Als Grundlage für die Berechnung der Zielkonfigurationen sowie der Suche kann zunächst jedoch eine Projektionstechnik vorgesehen sein, die eine Konfiguration, in der nicht alle Bedingungen erfüllt sind, auf eine ähnliche Konfiguration abbildet, die alle Bedingungen erfüllt. Insofern kann als Projektionstechnik ein zufälliger Gradientenabstieg (Randomized Gradient Descent, RGD) mit Bedingungen implementiert werden. Das Ziel ist die Abbildung einer Konfiguration k auf eine Konfiguration k', so dass eine gegebene Menge an Bedingungen in k' erfüllt ist und k' nicht weiter von k entfernt ist als d > 0. D.h. die vorgesehene Projektionstechnik ermöglicht es daher eine Konfiguration k, in der eine Menge an Bedingungen verletzt sind, minimal so abzuändern, dass die Bedingungen erfüllt werden. Der RGD-Algorithmus wird hierbei mit einer speziellen Distanzfunktion eingesetzt.

Die Distanzfunktion dist() kann wie folgt definiert sein: Gegeben sei die Konfiguration k und eine Menge an Bedingungen b1 bis bn:

1. Berechne für jedes bi einen Distanzwert di: sei f die Bedingungsfunktion und R die Bedingungsregion von bi. Falls R die Distanzberechnung unterstützt (siehe Berechnung B.2), dann gilt di = Minimum von MAX und Distanz von f(k) zu R. Falls R keine Distanzberechnung unterstützt, dann ist di = 0, falls f(k) enthalten in R. Ansonsten ist di = MAX. MAX ist eine Konstante > 0, hier: 100000.
2. Bilde das Maximum dmax aller Distanzwerte di

3. Der Wert der Distanzfunktion für die Konfiguration k ist dmax

Der RGD-Algorithmus projiziert eine Konfiguration k auf eine Konfiguration k', in der alle Bedingungen bi erfüllt sind, indem ein zufallsgesteuerter Gradientenabstieg durchgeführt wird. Dabei wird der folgende Prozess durchgeführt. Sei e > 0 gegeben und k' = k zu Beginn:

Funktion bool RGD(k, bi, k'):

1. Setze ZAEHLER = 0
2. Falls ZAEHLER > MAXIMUM, breche mit Rückgabewert Falsch ab
3. Erzeuge nach einer Gleichverteilung m Richtungsvektoren si der Dimension der Konfiguration k. Setze die Konfiguration ki = k' + e * si. Berechne vi = dist(ki) für alle ki.
4. Bestimme das Argument j mit minimalem Wert (argmin-Funktion) aller vi.
5. Falls vj = 0, setze k' = kj und breche mit Rückgabewert Wahr ab.
6. Falls vj >= dist(k), setze ZAEHLER = ZAEHLER+1 und gehe zu 2
7. Falls norm(k - k') > d, setze ZAEHLER = ZAEHLER+1 und gehe zu 2
8. Setze k' = kj
9. Gehe zu 2.

Die Zielkonfigurationen können dann in einem mehrstufigen Prozess erzeugt werden. Seien bi = (fi, Ri) die gegebenen Zielbedingungen mit Bedingungsfunktion fi und Bedingungsregion Ri:

1. Bestimme die Bedingungen bj aus bi, so dass fj invertierbar ist (siehe Berechnung B.1) und Rj die Berechnung von zufälligen Vektoren unterstützt (siehe Berechnung B.3).
2. Iteriere durch alle bj:

   a. Berechne einen zufälligen Wert rj aus Rj nach Berechnung B.3
   b. Berechne kj = $f^{-1}$(rj, k)

3. Falls RGD(k, bi, k') Wahr ist, füge k' zur Menge der Zielkonfigurationen hinzu

Im Hinblick auf die Suche einer stückweisen linearen Verbindung von einer Startkonfiguration k0 zur Menge der Zielkonfiguration kj kann der CBiRRT Algorithmus mit folgender Modifikation eingesetzt werden: der Schritt ConstrainConfig(kalt, kneu) wird ersetzt durch RGD(kalt, bi(t), kneu). Hierbei sind bi(t) die Währendbedingungen zum Zeitpunkt t, der im Planungsprozess schritthaltend inkrementiert wird.

Das Endergebnis des Bahnplanungsalgorithmus ist eine Sequenz von Zeitpunkten mit Konfigurationen (t1, k1), ..., (tm, km), so dass k1 die Startkonfiguration und km eine der Zielkonfigurationen aus der Menge der Zielkonfigurationen entspricht. Dabei sind die Währendbedingungen in k1 bis km-1 erfüllt. Die Zielbedingungen sind in km erfüllt.

Zur Bereitstellung einer geeigneten Regelung gemäß einem Ausführungsbeispiel kann der Regelungsalgorithmus hybride Positions- und Kraftregelung weiterentwickelt werden, um auf Basis von Während- und Zielbedingungen parametriert werden zu können. Die Interpretation der Während- und Zielbedingungen ist dabei wie folgt:

1. Währendbedingungen, die durch Einsatz von Regelung einzuhalten sind
2. Zielbedingungen, die, wenn sie erfüllt werden, die Ausführung unterbrechen

Im Rahmen des Ausführungsbeispiels ist der Regelungsalgorithmus als Proportional-Integral-Differential-Regler (PID-Regler) in den sechs Dimensionen x, y, z, rx, ry und rz implementiert vorgesehen. Der wesentliche Unterschied zum hybriden Positions- und Kraftregler liegt in der Fehlerberechnung, die die üblicherweise verwendete Selektionsvorschrift ersetzt. Der Regelungsalgorithmus unterstützt Währendbedingungen mit Positions-, Orientierungs-, Lage-, Kraft-, Drehmoment- oder Wrench-Bedingungsfunktion. Diese Bedingungsfunktionen sind einheitlich aufgebaut und basierend auf der Lage oder Wrench im TCP relativ zu einem bestimmten Koordinatensystem K.

Der Update-Schritt des PID-Reglers kann wie folgt umgesetzt werden:

1. Iteriere durch alle Währendbedingungen
2. Berechne für die aktuelle Konfiguration k den Wert f(k) der Bedingungsfunktion f der aktuellen Währendbedingung.
3. Die Fehlerberechnung im PID-Regler erfolgt für jede Dimension x, y, z, rx, ry und rz einzeln. Dabei werden folgenden Schritte in jeder Dimension i durchlaufen:

a. Berechne den Abstand di von f(k) zum Mittelpunkt der Region m an der Koordinate i

b. Berechne nach Berechnung B.4 die Ausdehnung ai der Bedingungsregion R in der Richtung, die durch i gegeben ist. Dabei ist explizit möglich, dass die Ausdehnung unendlich ist, zum Beispiel bei einer 2D-Ebene.

c. Falls Betrag di kleiner ai, dann setze den Fehler ei auf 0. Ansonsten ist der Fehler ei = ai - di

d. Wende das PID-Update auf den Fehler ei an und berechne den Sollwert si

4. Transformiere den Sollvektor s = [s1 s2 s3 s4 s5 s6] in den TCP nach den Transformationsvorschriften der Bedingungsfunktion

5. Falls eine Kraft, Drehmoment oder Wrench-Bedingungsfunktion gegeben ist, wandle den Sollvektor mit einer gegebenen Federkonstante nach dem Prinzip der Federkraft in einen Lagesollvektor um

6. Berechne die Summe der Sollvektoren und transformierten Lagesollvektoren aller Währendbedingungen

7. Bewege den Roboter relativ um die berechnete Summe

Somit führt der Roboter in einer gegebenen Dimension i entweder eine Positions-, eine Kraft- oder eine zeitgleiche Positions- und Kraftregelung durch, je nach vorliegenden Währendbedingungen.

Der Regelungsvorgang wird abgebrochen, falls alle Zielbedingungen in der aktuellen Konfiguration erfüllt sind.

Zusätzlich können die Regelungsalgorithmen einfach auf die Verwendung von Zielbedingungen erweitert werden, zum Beispiel eine Positionsregelung im Gelenkwinkelraum und/oder im kartesischen Raum oder eine Kraftregelung. Dabei wird in der Regelungsschleife die aktuelle Konfiguration k berechnet. Die Regelung wird erfolgreich abgebrochen, falls alle Zielbedingungen in k erfüllt sind.

Gemäß einem Ausführungsbeispiel der Erfindung stellen Während- und Zielbedingungen eine besonders vorteilhafte Parametrierung zur Erzeugung von Bewegungsbahnen mittels Bahnplanung und Regelung dar, die erlaubte Abweichungen explizit modellieren können und daher zur Steigerung der Robustheit führen können. Die Programmierung mittels Während- und Zielbedingungen ist aufgrund der algorithmischen Komplexität nur Experten in der Robotik vorbehalten. In raffinierter Weise werden daher Bewegungsschablonen eingesetzt, die Ausführungsmodule mit Lernmodulen kombinieren. Die Ausführungsmodule können mittels Bedingungen - insbesondere mittels Während- und Zielbedingungen - parametriert werden. Lernmodule können einfache maschinelle Lernverfahren einsetzen, um Während- und Zielbedingungen als Parameter für die Ausführungsmodule aus wenigen Konfigurationen zu erzeugen. Das Lernmodul an sich repräsentiert einen Prozess, der eine Bedienperson schrittweise, beispielsweise anhand schematischer Darstellungen der wenigen Konfigurationen, durch deren Erzeugung führt. Somit können selbst Nicht-Experten Roboterprogramme für Aufgaben auf einfache Weise erstellen, die bisher eine aufwändige und komplexe textuelle Programmierung von Abbruch- oder Sollkriterien erforderten.

Die Bewegungen eines Roboters werden durch Bewegungsschablonen beschrieben. Eine Bewegungsschablone besteht aus einem oder mehreren Ausführungsmodulen und einem Lernmodul. Jedes Ausführungsmodul ist entweder ein primitiver Operator (Basic Operator), d.h. er kann nicht weiter zerlegt werden, oder es besteht wiederum aus mehreren Ausführungsmodulen (Macro Operator). Dabei existieren mindestens zwei Klassen an Ausführungsmodulen: Regler (Controller) sowie Bahnplaner (Motion Planner). Bahnplaner erzeugen auf Basis von Während- und Zielbedingungen eine Bewegungsbahn. Controller sind vom Typ der beschriebenen Positionsregler im Gelenkwinkelraum, Positionsregler im kartesischen Raum, Kraftregler oder erweiterten hybriden Positions-Kraftregler. Controller bzw. Regler verarbeiten die Während- und Zielbedingungen und erzeugen während der Ausführung eine Bewegungsbahn.

Ausführungsmodule können durch eine Menge aus Während- und/oder Zielbedingungen parametriert werden. Die Während- und Zielbedingungen, die in der Bewegungsschablone gespeichert sind, sind vorzugsweise nur teilweise parametriert: für jede Bedingung ist der Typ der Bedingungsfunktion f fest sowie der Typ der Bedingungsregion R fest. Die Parameter der Bedingungsfunktion sind frei, also zum Beispiel das Koordinatensystem K bei Lagebedingungen bzw. die Lage des TCPs. Ebenso sind die Parameter der Bedingungsregion, d.h. zum Beispiel Mittelpunkt, Orientierung und Ausdehnung eines achsorientierten Würfels frei. Die freien Parameter werden durch Lernmodule berechnet.

Das Ziel im Hinblick auf die Interaktion mit einem Benutzer bzw. einer Bedienperson im Rahmen des Initialisierungsprozesses bzw. des Teach-Prozesses ist eine schematische Darstellung der zu erzeugenden Konfiguration zu erzeugen, damit der Benutzer eine semantisch richtige Konfiguration für die Berechnung der freien Parameter der Ausführungsmodule erzeugt. Zum Beispiel muss der Benutzer Kontakt mit einem Gegenstand herstellen, um eine Kraftmessung mit dem KMS zu ermöglichen.

Die Darstellung erfolgt schematisch, da die Bewegungsschablonen allgemein definiert und unabhängig vom konkreten Aussehen der Objekte, des Greifers bzw. des Roboters sind.

Die schematische Darstellung kann auf mehrere Arten erfolgen:

1. Darstellung eines Videos mit einer realen und/oder computeranimierten Darstellung der Ausführung der Bewegungsschablone und/oder des Prozesses der Konfigurationserzeugung in einem prototypischen Beispiel der Bewegungsschablone. Dabei werden in letzterem Fall die einzelnen Schritte, d.h. die einzelnen zu erzeugenden Konfigurationen hervorgehoben, zum Beispiel durch Pausieren im Video.

2. Verwendung eines Dialogsystems, um den Nutzer schrittweise durch den Prozess der Konfigurationserzeugung zu führen, so dass der Nutzer bereits erzeugte Konfigurationen zurücknehmen und Teile des Prozesses wiederholen kann. Dabei wird für jede zu erzeugende Konfiguration mindestens ein Dialogfenster anzeigt mit einer schematischen Visualisierung der zu erzeugenden Konfiguration analog zu 1.

Die freien Parameter können von den Lernmodulen auf Basis der Konfigurationen Ti berechnet werden. Dabei seien der Bedingungsregionstyp sowie die Bedingungsfunktion gegeben.

Wenn T1 bis Tn die Konfigurationen zur Berechnung der freien Parameter der Bedingung b = (f, R) sind. Dann gilt:

1. Berechne f(T1), ... f(Tn)
2. Setze eine Gütefunktion g(Rp) >= 0 fest, die einer Bedingungsregion Rp ohne freie Parameter einen numerischen Wert zuweist. In der vorliegenden Arbeit wurde g(R) = gewichtete Summe aus Volumen und Oberfläche der Region R gesetzt.
3. Verwende ein nicht-lineares Optimierungsverfahren, zum Beispiel den Simplex- oder Rosenbrock-Algorithmus, um das folgenden Optimierungsproblem zu lösen: Finde Werte für die freien Parameter von R, so dass Rp bzgl. g(R) minimal ist und f(T1) bis f(Tn) in Rp enthalten sind.

Der Einsatz eines vorgegebenen Lernmoduls für eine Bewegungsschablone, die vorzugsweise teilweise parametriert ist, ermöglicht die Bestimmung von Während- und Zielbedingungen mit nur einer geringen Menge von Konfigurationen, was zu einer Reduktion der Programmierzeit führt und gleichzeitig das Prozessergebnis überprüfbar macht, was für den robusten industriellen Einsatz erforderlich bzw. besonders vorteilhaft ist. Im Vergleich mit textueller oder dialoggestützter Programmierung muss der Programmierer nicht direkt die Parameter der Bewegungsbefehle eingeben, sondern diese Parameter werden aus dem vorgestellten Teach-Prozess automatisch berechnet.

Für jeden Regelungstyp und jedes Zielsystem können Kompilierungsvorschriften vorhanden sein, die das Ausführungsmodul in ausführbaren Robotercode übersetzen. Dabei wird die Auswertung von Zielbedingungen direkt im Robotercode nachgebildet. Währendbedingungen werden abhängig vom Reglertyp nachgebildet. Bei Positionsreglern werden nur Währendbedingungen, die die Lage oder Gelenkwinkel des Roboterarms betreffen, eingeregelt (zum Beispiel mit den zuvor beschriebenen Verfahren). Bei Kraftreglern Währendbedingungen für die gemessenen KMS Werte. Bei hybrider Positions/Kraftregelung werden Währendbedingungen für die Position und KMS Werte berücksichtigt. Dabei wird die Bedingungsregion R analysiert, um die Raumachsen festzulegen, die kraft- oder positionsgesteuert werden. Eine Ausdehnung in einer gewissen Raumachse größer einem Schwellwert wird als unendliche Ausdehnung bewertet. Raumachsen mit unendlicher Ausdehnung werden bei Positions-Bedingungen nicht positions- und bei Kraft-Bedingungen nicht kraftgeregelt.

Das erfindungsgemäße Verfahren bzw. das erfindungsgemäße System und/oder deren unterschiedlichen, vorteilhaften Ausgestaltungen stellen eine Erweiterung des klassischen Teach-Ins auf Roboterprogramme mit Notwendigkeit zur Berücksichtigung von Abweichungen dar. Das Ergebnis ist ein ausführbares Programm, das nicht nur Bewegungsbefehle wie beim Teach-In enthält, sondern bei dem ein Bewegungsbefehl vorzugsweise noch Während- und Zielbedingungen besitzt. Die integrierten Regelungsalgorithmen ändern die Roboterbewegung entsprechend dem Reglertyp ab, um die Währendbedingungen einzuhalten und die Zielbedingungen zu erreichen. Die beschriebenen möglichen vorteilhaften Ausgestaltungen ermöglichen somit die einfache Einrichtung von Roboterprogrammen mit Regelungsstrategien, die sonst nur sehr zeitaufwendig durch dialoggestützte oder textuelle Programmierung manuell erstellt werden können.

Mögliche Verfahrensschritte sind somit: Teachen von Konfigurationen auf Basis von Schablonen, Berechnung der Während- und Zielbedingungen, Berechnung einer prototypischen Bewegungsbahn, Abbildung auf Regelungsverfahren mit Während- und Zielbedingungen, Kompilierung zur Erzeugung von Robotercode.

Das ersetzt einen analogen Vorgang bei der dialoggestützten bzw. textuellen Programmierung, wonach der Programmierer in der Programmiersprache ein Regelungsverfahren entwickelt und dessen Parameter für eine vorliegenden Aufgabe manuell festlegt; er erzeugt und parametriert Ziel- und Abbruchbedingungen in der Programmiersprache. Startposen und Zwischenpunkte werden durch Teach-In am Roboter erzeugt.

Das erfindungsgemäße Verfahren und das erfindungsgemäße System und/oder dessen vorteilhafte Ausgestaltungen ermöglichen dagegen eine schnellere Einrichtung von komplexen Roboterprogrammen bei gleichzeitig geringeren Anforderungen an die Bedienperson, wodurch bisher aus ökonomischen oder komplexitätstechnischen Gründen nicht automatisierte Anwendungen für die Automation erschlossen werden können. Zusätzlich können erzeugte Teillösungen, d.h. Mengen von parametrierten Bewegungsschablonen, einfach wiederverwendet werden, da sie einfach angepasst werden können, indem mit den Lernmodulen einzelne Konfigurationen abgeändert werden.

Konkret entfällt beim definierten Aufgabenprofil, zum Beispiel einer durchschnittlichen Montageaufgabe, die zeitaufwendige, manuelle Einrichtung von Soll- und Abbruchkriterien für eine große Zahl an Bewegungsbefehlen durch den Programmierer mittels einer dialoggestützten oder textuellen Programmierschnittstelle. An deren Stelle treten eine raffiniert einfache Einrichtung des Roboterprogramms aus einer Menge von Bewegungsschablonen sowie das Teachen von wenigen, klar definierten Konfigurationen für jedes Lernmodul. Das daraus abgeleitete Roboterprogramm enthält automatisch Soll- und Abbruchkriterien in Form von Während- und Zielbedingungen. Im Gegensatz zu Teach-In oder Playback muss somit nicht ein bestimmter Wegpunkt angefahren werden, sondern die Bewegung kann erfolgreich ausgeführt werden, wenn die Bedingungen erfüllt sind, d.h. zum Beispiel wenn ein Wegpunkt aus einer Region angefahren werden kann, wodurch die Ausführung flexibler wird. In Form der Bedingungen liegt zusätzlich Information vor, wie eine Abweichung kompensiert werden kann. Das Roboterprogramm ist somit tolerant gegenüber Abweichungen entsprechend der Ausdehnung der Bedingungsregion.

Nachfolgend sind beispielhaft vorteilhafte Definitionen zur Anwendung im Rahmen von bevorzugten Ausgestaltungen der Erfindung angegeben.

Eine Konfiguration (configuration) ist in der Bahnplanungsfachliteratur eine eindeutige Beschreibung des Zustands eines Robotersystems. Im vorliegenden Fall kann eine Konfiguration daher gegeben sein als ein n-dimensionaler, reellwertiger Vektor, der folgende Information enthält:

- die Werte aller steuer- und nicht-steuerbaren Freiheitsgrade des Robotersystems, d.h. bei einem Sechsachs-Industrieroboter sechs Gelenkwinkelwerte
- die Werte aller steuer- und nicht-steuerbaren Freiheitsgrade der am Roboter angebrachten Werkzeuge, d.h. bei einem elektrischen Backengreifer ein Wert für die Greiferbackenstellung
- die Werte der erfassten Sensordaten der am Roboter angebrachten Sensoren, d.h. bei einem sechs dimensionalen Kraft-Momenten-Sensor drei Werte für die gemessenen Kräfte in Raumrichtung x, y und z sowie drei Werte für die gemessenen Drehmomente in Raumrichtung x, y und z
- einen Wert für den Zeitpunkt t

Ein Konfigurationsraum (configuration space) ist die Menge aller Konfigurationen, die das Robotersystem einnehmen kann. Dabei werden physikalische Randbedingungen, wie zum Beispiel eine ansteuerbare Gelenkwinkelstellung, die zu einer Selbstkollision des Roboters führt, ignoriert. Wenn eine Konfiguration aus n Koordinaten besteht und jede Koordinate Werte zwischen Li und Ui annehmen kann, dann ist der Konfigurationsraum definiert als der Hyperwürfel mit Dimension n und Kantenlängen Ui - Li sowie Mittelpunkt (Li+Ui)/2.

Eine Bewegungsbahn (motion) kann als eine Funktion b angegeben werden, die jedem Punkt aus dem abgeschlossenen Intervall von 0 bis 1 eine Konfiguration zuweist und stetig ist. Der Wert von b an der Stelle 0 ist die Startkonfiguration. Der Wert von b an der Stelle 1 ist die Zielkonfigurationen. Eine Bewegungsbahn ist daher eine stetige Verbindung im Konfigurationsraum.

Eine Bedingung (constraint) kann als eine Funktion g angegeben werden, die einer Konfiguration k, den Wert 0 oder 1 zuweist. Man sagt eine Bedingung g sei in der Konfiguration k erfüllt, genau dann wenn g(k) = 1. Ansonsten ist die Bedingung nicht erfüllt.

Eine Währendbedingung (runtime constraint) kann als eine zeitabhängige Bedingung angegeben werden, d.h. sie definiert für jeden Zeitpunkt t eine Bedingung. Sie wird auf die Werte an den Stellen größer gleich 0 und kleiner 1 einer Bewegungsbahn angewendet wird. Eine Währendbedingung g(t) ist auf einer Bewegungsbahn b erfüllt, genau dann wenn g(t)(b(t)) = 1 ist für alle t >=0 und t < 1.

Eine Zielbedingung (goal constraints) kann als eine Bedingung angegeben werden, die auf den Wert an der Stelle 1 einer Bewegungsbahn angewendet wird. Eine Zielbedingung g ist auf einer Bewegungsbahn b erfüllt, genau dann wenn g(b(1)) = 1.

Eine bedingungsbasierte Bewegungsbeschreibung (constraint-based motion representation) ist defnierbar als eine Menge von Während- und eine Menge von Zielbedingungen. Eine Bewegungsbahn erfüllt eine bedingungsbasierte Bewegungsbeschreibung, wenn alle Während- und alle Zielbedingungen auf der Bewegungsbahn erfüllt sind.

Im Rahmen der Ausführung einer Roboterbewegung unter Verwendung von Während- und Zielbedingungen können Bewegungsbahnen zum Beispiel wie folgt generiert werden: durch den Einsatz von Bewegungsplanung und/oder durch den Einsatz von Regelung. Bei der Bewegungsplanung wird eine Bewegungsbahn vor der Ausführung auf dem Roboter erzeugt. Bei der Regelung wird eine Bewegungsbahn durch einen Regelungsalgorithmus während der Ausführung erzeugt. Dabei ist die Startkonfiguration konstant und entspricht dem Beginn der Bewegung. Die Zielkonfiguration ist immer die aktuelle Konfiguration, in der sich der Roboter zum aktuellen Zeitpunkt befindet. Damit wächst die mit einem Regelungsalgorithmus erzeugte Bahn kontinuierlich an. Ein Roboter führt eine Bewegung erfolgreich durch, wenn alle für die Bewegungsbahn gegebenen Während- und Zielbedingungen erfüllt sind. Der Roboter wird unter Einhaltung von Regelungsalgorithmen seine Bewegung so adaptieren, dass die Währendbedingungen eingehalten werden. Sobald die Zielbedingungen erfüllt sind, wird die Bewegung erfolgreich beendet. Ansonsten ist die Ausführung nicht erfolgreich.

Es gibt nun weitere verschiedene Möglichkeiten, die Lehre der vorliegenden Erfindung in vorteilhafter Weise auszugestalten und weiterzubilden. Dazu ist einerseits auf die dem Patentanspruch 1 nachgeordneten Patentansprüche und andererseits auf die nachfolgende Erläuterung weiterer bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen

Fig. 1 in einer schematischen Ansicht ein beispielhaftes Roboterprogramm wie es ein Mensch manuell erstellen würde, um das Einstellen einer Schraube bis auf ein vorgebbares Drehmoment mit einem Roboter zu bewerkstelligen (Stand der Technik),

Fig. 2 in einer schematischen Ansicht ein Ausführungsbeispiel eines erfindungsgemäßen Verfahrens oder Systems, wobei der hierarchische Aufbau, insbesondere während eines Kompilierungsprozesses, einer Bewegungsschablone angedeutet ist,

Fig. 3 in einer schematischen Ansicht den Aufbau sowie Parameter einer Bewegungsschablone gemäß einem Ausführungsbeispiel eines erfindungsgemäßen Verfahrens oder Systems,

Fig. 4 in einer schematischen Ansicht einen Programmierprozess gemäß einem Ausführungsbeispiel eines erfindungsgemäßen Verfahrens oder Systems,

Fig. 5 in einer schematischen Ansicht einzelne Komponenten zur Programmierung eines Roboterprogramms, insbesondere mit Während- und Zielbedingungen, durch Teaching gemäß einem Ausführungsbeispiel eines erfindungsgemäßen Verfahrens oder Systems,

Fig. 6 - 10 in einer schematischen Ansicht einen Initialisierungsprozess bzw. einen Teach-Prozess - gemäß einem Ausführungsbeispiel eines erfindungsgemäßen Verfahrens oder Systems - zur Aufzeichnung von Konfigurationen für einen Schraubvorgang, die von einer Bedienperson erzeugt werden,

Fig. 11 in einer schematischen Ansicht einen beispielhaften Zielbereich für ein Ausführungsbeispiel eines erfindungsgemäßen Verfahrens oder Systems,

Fig. 12 ein Beispiel einer grafischen Anleitung für eine Bedienperson zur Erzeugung von zu teachenden bzw. aufzuzeichnenden Konfigurationen gemäß einem Ausführungsbeispiel eines erfindungsgemäßen Verfahrens oder Systems, und

Fig. 13 in einer schematischen Ansicht den Ablauf eines Initialisierungsprozesses bzw. eines Teach-Prozesses mittels eines Lernmoduls zur Erzeugung der Parameter für eine Bewegungsschablone gemäß einem Ausführungsbeispiel eines erfindungsgemäßen Verfahrens oder Systems.

Die Figuren Fig. 1 bis Fig. 12 umfassen ein gemeinsames Anwendungsbeispiel, nämlich die Programmierung eines Roboters zum Eindrehen einer Schraube in ein Werkstück bis auf ein gewisses Drehmoment durch einen Roboter.

Fig. 1 zeigt in einer schematischen Ansicht ein beispielhaftes Roboterprogramm 1 wie es - gemäß dem Stand der Technik - ein Mensch manuell erstellen würde, um das Eindrehen einer Schraube bis auf ein vorgebbares Drehmoment mit einem Roboter zu bewerkstelligen. Im Konkreten umfasst das Roboterprogramm 1 gemäß Fig. 1 Anweisungen bzw. Roboterbefehle zur Durchführung/Erledigung der genannten Aufgabe, und zwar so wie es ein Mensch heutzutage manuell programmieren bzw. erstellen müsste. Die Kästchen sind einzelne Roboterbefehle mit Parametern. P1, P2, P3 und P4 sind geteachte Punkte, die manuell als Parameter, vorzugsweise durch den Programmierer, in dass Programm integriert wurden. SENSOR[2] liest den z-Wert des Kraftmomentsensors am Roboter aus, SENSOR[5] das Drehmoment um z. OUT[0] = 1 bzw. 0 aktiviert bzw. deaktiviert den Schraubendreher am Roboter.

Das in Fig. 1 dargestellte, beispielhafte Roboterprogramm 1 umfasst folgende Programmanweisungen PA1 bis PA14:

PA1: Bewege schnell zur Startposition P1 oberhalb der Schraube
PA2: Rücke an mit Schraubendreher bis P2, d.h. 2mm oberhalb Schraube
PA3: Solange gemessener Kraftwert in z-Richtung kleiner 2 Newton
PA4: Bewege relativ zum Tool-Center-Point 1 mm in z-Richtung
PA5: Schleifenende
PA6: Aktiviere Schraubendreher
PA7: Speichere aktuelle Tool-Center-Position in P4

PA8: Aktiviere Kraftregelung und stelle 5N in z-Richtung ein
PA9: Solange Positionsänderung kleiner als 1cm und gemessener Drehmomentwert um z-Achse kleiner 10Nm
PA10: Warte einen Zeitschritt
PA11: Schleifenende
PA12: Schraubvorgang erfolgreich wenn Drehmomentwert mindestens 10Nm
PA13: Deaktiviere Schraubendreher
PA14: Rücke ab von der festgezogenen Schraube auf Position P3

Gemäß dem Beispiel aus Fig. 1 muss der Programmierer bzw. der Mensch sich die Struktur des Programms sowie einzelne Parameter wie "< 2", "< 0.01", "< 10" etc. überlegen bzw. diese wählen. Mit Hilfe eines Teach-Panels kann der Programmierer Zwischenpunkte anfahren und in das Programm einfügen, insbesondere die Punkte P1 bis P4. Es erfordert einen sehr hohen Aufwand die Struktur des Programms festzulegen und verschiedene Abbruchkriterien festzulegen.

Fig. 2 zeigt in einer schematischen Ansicht ein Ausführungsbeispiel eines erfindungsgemäßen Verfahrens oder Systems, wobei der hierarchische Aufbau einer Bewegungsschablone 2 ("Screwing"), insbesondere während eines Kompilierungsprozesses, angedeutet ist. Folglich zeigt Fig. 2 wie in einem Kompilierungsprozess aus den Bewegungsschablonen schrittweise der Roboterprogrammquelltext automatisch erzeugt werden kann, ohne textuelle Programmierung. Dabei entspricht üblicherweise der erzeugte Quelltext nicht genau dem, den ein Mensch schreiben/erstellen würde. In Fig. 2 ist dies zum Zwecke der einfacheren Darstellung angenommen worden.

Die Bewegungsschablone 2, rechts dargestellt in Fig. 2, besteht aus mehreren Ausführungsmodulen 3. Jedes der Ausführungsmodule 3 kann prinzipiell wieder eine Bewegungsschablone oder ein oder mehrere Ausführungsmodule 4 umfassen (hierarchische Repräsentation). Dadurch können Teilprogramme repräsentiert und wiederverwendet werden.

In der untersten Ebene befinden sich Ausführungsmodule, die nicht weiter zerlegt werden. Enthalten sind roboterprogrammtypische Befehle, wie zum Beispiel Ein/Ausgänge der Steuerung setzen. Relevant für den Kompilierungsprozess ist das verwendete Ausführungsmodul Controller. Type bezeichnet den Typ des Controllers, insbesondere Positions-, Kraft- oder hybride Positions-Kraftregelung. Ri bzw. Gi sind die Während- bzw. Zielbedingungen. Der Regler des jeweiligen Typs ist so implementiert, dass die Währendbedingungen Ri eingehalten und die Zielbedingungen Gi erreicht werden sollen. Für die Ausführungsmodule dieser Ebene sowie die Typen der Während- und Zielbedingungen sind Regeln hinterlegt, wie diese auf ausführbaren Roboterprogrammquelltext für die jeweilige Zielrobotersteuerung abgebildet werden können. Nach Berechnung aller Parameter werden diese Regeln angewendet, um den ausführbaren Quelltext zu erzeugen.

Fig. 3 zeigt in einer schematischen Ansicht den Aufbau sowie Parameter einer Bewegungsschablone 2 ("Screwing") gemäß einem Ausführungsbeispiel eines erfindungsgemäßen Verfahrens oder Systems. Die Bewegungsschablone 2 besteht aus Ausführungsmodulen 3, Strukturinformation (siehe Pfeile über Verbindungen im Graph) über die Reihenfolge der Ausführungsmodule 3 und einem Lernmodul 5. Die Ausführungsmodule 3 können hierarchisch aus weiteren Ausführungsmodulen (oder aus vorzugsweise Bewegungsschablonen) bestehen.

Die Parameter T1 bis T6 der Bewegungsschablone 2 sind Konfigurationen, die variable, vorzugsweise alle variablen, Freiheitsgrade des Robotersystems (zum Beispiel Armstellung, Greiferstellung), Sensordaten (zum Beispiel Kraftmomentenmessungen) und Referenzpunkte auf CAD-Modellen (zum Beispiel Kontaktpunkte auf einem 3D-Modell) umfassen bzw. enthalten.

Die Struktur von Ausführungsmodulen spiegelt die Ausführungsreihenfolge des daraus erzeugten Roboterprogrammquelltextes wieder und entspricht der realen Ausführungsreihenfolge.

Lernmodule werden entsprechend ihrer Struktur ausgeführt und berechnen aus Konfigurationen T1 - Tn die Parameter der Ausführungsmodule, also insbesondere Währendbedingungen Ri und Zielbedingungen Gj. Hierbei bezeichnet B.f die Bedingungsfunktion der Bedingung B sowie B.R die Bedingungsregion der Bedingung B.

Im Konkreten kann gemäß dem in Fig. 3 dargestellten Ausführungsbeispiels eine Bewegungsschablone 2 ("Screwing") aus den Ausführungsmodulen 3, nämlich MoveToState, MoveToContact, FastenScrew und Depart bestehen. Die Parameter der Ausführungsmodule 3 sind - allgemein formuliert - Währendbedingungen (Ri) und Zielbedingungen (Gi). Diese Während- und Zielbedingungen werden durch vordefinierte Funktionen des Lernmoduls schrittweise berechnet.

Das Ausführungsmodul MoveToState in Fig. 3 hat nur eine Zielbedingung G1. Diese Zielbedingung hat eine Bedingungsfunktion f vom Typ Gelenkwinkelbedingung, d.h. für eine Konfiguration k ist f(k) der reellwertige Vektor bestehend aus allen Gelenkwinkelwerten des Roboters, sowie eine Bedingungsregion R vom Typ Kugel mit Mittelpunkt entsprechend der geteachten Konfiguration T1 oberhalb der Schraube und Radius entsprechend der Ungenauigkeit des Robotergelenkpositionssensors, zum Beispiel 0.0001 RAD. MoveToState besteht intern aus einem Bahnplanungs-Ausführungsmodul "MotionPlanner" (vgl. Fig. 2) sowie einem Regler-Ausführungsmodul "Controller". Das Bahnplanungs-Ausführungsmodul berechnet mit dem definierten Bahnplanungsprozess eine Bewegungsbahn P1 von der Startkonfiguration zu einer Konfiguration, die die Zielbedingung G1 erfüllt, d.h. bis auf die Ungenauigkeit des Robotergelenkpositionssensors die geteachte Konfiguration T1 anfährt. Die berechnete Bewegungsbahn wird dann mit dem Regler vom Typ Positionsregler ausgeführt und ist erfolgreich, wenn die letzte, über die Robotergelenkpositionssensoren gemessene Konfiguration die Zielbedingung erfüllt. Der Roboter fährt somit von der aktuellen Konfiguration zur Konfiguration, in der der Schraubendreher oberhalb der Schraube positioniert ist.

Das Ausführungsmodul MoveToContact gemäß Fig.3 besitzt die Währendbedingung R1 und die Zielbedingungen G2 und G3. Es besteht aus einem Bahnplanungs-Ausführungsmodul und zwei Regelungs-Ausführungsmodulen. Die Währendbedingung R1 beschreibt die lineare Bewegung von der Konfiguration oberhalb der Schraube zu einer Konfiguration, in der der Schraubendreher Kontakt mit der Schraube hat. Die Bedingungsfunktion ist eine Lagebedingungsfunktion, die den TCP relativ zu dem Koordinatensystem beschränkt, das exakt der Lage des TCPs in der Startkonfiguration entspricht. Die Bedingungsregion ist ein Würfel, der aus den in einem Initialisierungsprozess geteachten Konfigurationen T1, T2 und T3 berechnet wird. D.h. die Ausdehnung in Richtung der Schraube entspricht in der Länge der gefahrenen Strecke von der Konfiguration oberhalb der Schraube (T1) zu der Konfiguration in Kontakt mit der Schraube (T2 und T3). Die Ausdehnung orthogonal dazu entspricht der Abweichung, die der Mensch von T1 nach T2 und T3 von der linearen Bewegung geteacht hat. G2 ist eine Lagebedingung mit gleicher Bedingungsfunktion wie R1, aber unterschiedlicher Bedingungsregion. Die Bedingungsregion ist ein Würfel mit minimaler Ausdehnung, der die Werte der Bedingungsfunktion an T2 und T3 enthält.

Die einheitliche, komplexe Parametrierung der Ausführungsmodule mit Während- und Zielbedingungen ermöglicht es, ein einheitliches maschinelles Lernverfahren zur Erzeugung dieser Parameter aus geteachten Konfigurationen anzugeben.

Das Ziel des Lernmoduls 5 der Bewegungsschablone 2 ist es die Parameter der Ausführungsmodule 3, die in Form von Während- und Zielbedingungen gegeben sind, aus wenigen Konfigurationen zu erzeugen. Da Konfigurationen über mehrere, intuitive Eingabekanäle erzeugt werden können, ist somit ein erheblich einfacheres Programmierverfahren gegeben als mit der textuellen Programmierung, die in funktioneller Hinsicht vergleichbare Roboterprogramme (mit Abbruchkriterien und Reglern) erzeugen kann. Der Vorteil gegenüber gängigen, aus der Praxis bekannten Verfahren liegt in der minimalen Anzahl an Konfigurationen (oder auch Trainingsbeispielen in der maschinellen Lernliteratur), die notwendig sind, um vergleichbar komplexe Roboterprogramme zu erzeugen. Dies wird ermöglicht, indem explizite Vorschriften zur Berechnung der freien Parameter der Während- und Zielbedingungen bereits in der Aktionsbeschreibung, insbesondere in der Beschreibung der Bewegungsschablone, abgespeichert werden. Diese Vorschriften sind hier repräsentiert als die einzelnen Prozessschritte, die im Lernmodul 5 ausgeführt werden.

Im Lernmodul ist eine Menge von Prozessschritten definiert, die jeweils basierend auf einer Menge von Konfigurationen, siehe T1 bis T6 in Fig. 3, eine Während- oder Zielbedingung berechnen. Diese Während- und Zielbedingungen dienen dann als Eingabe für die Ausführungsmodule.

Gemäß Beispiel aus Fig. 3 hat das Ausführungsmodul MoveToContact drei Parameter, nämlich Währendbedingung R1 sowie Zielbedingungen G2 und G3. R1 ist eine Lagebedingung mit Bedingungsregiontyp Cylinder. Die freien Parameter von R1, d.h. die Lage des Mittelpunkts des Cylinders, dessen Höhe und Radius, werden berechnet aus den Konfigurationen T1, T2 und T3. Dazu wird die Bedingungsfunktion f auf T1, T2 und T3 angewendet mit Ergebnis R1.f(T1), R1.f(T2), R1.f(T3). Die verwendete Funktion Cylinder(A1, A2, ..., An) berechnet dabei die freien Parameter der Bedingungsregion aus den Vektoren A1 bis An unter Verwendung eines Optimierungsalgorithmus. Der berechnete Cylinder approximiert die Bewegung, die der TCP auf dem Weg zum Kontaktpunkt durchzuführen hat.

Gemäß dem Ansatz eines Ausführungsbeispiels des erfindungsgemäßen Verfahrens wird ein Großteil der Struktur durch die Ausführungsmodule der Bewegungsschablonen erzeugt. Die Abbruchkriterien werden automatisch mit Hilfe der Während- und Zielbedingungen festgelegt, die aus geteachten Konfigurationen berechnet werden.

Fig. 4 zeigt die Auflistung eines Programmierprozesses gemäß einem Ausführungsbeispiel eines erfindungsgemäßen Verfahrens oder Systems. Der Programmierprozess umfasst folgende Teilschritte TS1 bis TS6:

TS1: Bewegungschablone in Gesamtprogramm einfügen
TS2: Ausführung des Lernmoduls
TS3: Rückfragen an Nutzer zur Erzeugung von Schlüsselkonfigurationen
TS4: Ausführung Berechnungsvorschriften für Während- und Zielbe dingungen
TS5: Ausführung Bahnplanung zur Berechnung von Pfaden auf Basis von Während- und Zielbedingungen
TS6: Kompilierung zu ausführbarem Roboterprogrammquelltext

Fig. 5 zeigt die Visualisierung der eingesetzten Komponenten. Eine Bedienperson 6 erzeugt Konfigurationen direkt am Roboter 7 und mit Hilfe eines Computers/PCs 8 (bei Punkten am CAD-Modell). Der Roboter 7 verfügt über einen oder mehrere Sensoren 9 und einen Schraubendreher 10, um die Umgebung wahrzunehmen (zum Beispiel Kräfte oder visuell). Mit Hilfe des Computers/PCs 8 wird Quelltext für die Robotersteuerung 11 erzeugt, die dort bzw. auf dem Roboter 7 lauffähig ist.

Die Figuren Fig. 6, Fig. 7, Fig. 8, Fig. 9 und Fig. 10 zeigen die Visualisierung der von einer Bedienperson erzeugten Konfigurationen T1 - T6 zur Programmierung des Roboters 7 für einen Schraubvorgang im Rahmen des in Fig. 5 dargestellten Anwendungsumfelds.

Fig. 6 zeigt den Start des Prozesses, d.h. des Initialisierungsprozesses bzw. des Teach-Prozesses, wodurch der Roboter 7 zur Durchführung der Arbeitsoperation derart programmiert werden soll, dass mit dem Roboter 7, der einen Sensor 9 und einen Schraubendreher 10 umfasst, eine Schraube 12 in ein Werkstück 13 geschraubt wird.

Gemäß Fig. 7 führt die Bedienperson den Schraubendreher 10 direkt oberhalb der Schraube 12 ohne Kontakt, so dass die Konfiguration T1 aufgezeichnet wird. Die Zielbedingung G1 mit vordefiniertem Typ der Bedingungsfunktion f = Gelenkwinkelbedingungsfunktion sowie Typ der Bedingungsregion R = Sphere wird aus der Konfiguration T1 berechnet. Die Funktion Sphere berechnet nach einem Gütekritierum die optimale Kugel, die Konfiguration T1 umschließt:

$$G1.R = Sphere(G1.f(T1))$$

Die Zielbedingung G1 besagt, dass der Roboter genau diese Armstellung einnehmen soll.

Gemäß Fig. 8 führt die Bedienperson den Roboter 7 auf Kontakt mit der Schraube 12. Die Bedienperson nimmt zwei redundante Konfigurationen T2 und T3 auf. Aus den zwei (ggf. auch mehr) Konfigurationen wird die Zielbedingung G3 für die Kraft beim auf Kontaktfahren mit der Schraube berechnet. Der Typ der Bedingungsfunktion ist Kraftbedingungsfunktion mit Tool-Center-Point TCP in der Spitze des Schraubendrehers 10 sowie Koordinatensystem exakt gleich der Lage des TCP in der Startkonfiguration, d.h. T2. Der Typ der Bedingungsregion ist Cube.

Die Funktion Cube berechnet basierend auf den Werten der Bedingungsfunktion für T2 und T3, d.h. der gemessenen Kräfte transformiert in den TCP, die Bedingungsregion von G3:

$$G3.R = Cube(G3.f(T2), G3.f(T3))$$

Zusätzlich wird aus der Differenz aus den voherigen Konfigurationen T1 und T3 die Richtung der Bewegung berechnet und als Währendbedingung abgespeichert, d.h. der Roboter 7 muss sich in die geteachte Richtung bewegen.

Die Funktion Cylinder berechnet für die Werte der Bedingungsfunktion in T1, T2 und T3 den optimalen Cylinder, der diese Werte enthält. Dabei ist R1.f eine Lagebedingungsfunktion.

$$R1.R = Cylinder(R1.f(T1), R1.f(T2),F1.f(T3))$$

Analog dazu wird die Zielbedingung G2 berechnet. Allerdings ist der Bedingungsregionstyp: Cube.

$$G2.R = Cube(G2.f(T2), G2.f(T3))$$

G2 wird zur Berechnung der Bewegung zum Kontaktpunkt verwendet. Bei der Ausführung wird die berechnete Bewegung ausgeführt und erfolgreich abgebrochen, falls G3 erfüllt ist.

Gemäß Fig. 9 aktiviert die Bedienperson den Schraubendreher 10, dreht die Schraube 12 ein und stoppt den Schraubendreher 10. Die Bedienperson wiederholt den Prozess und speichert zwei redundante Konfigurationen T4 und T5 jeweils am Ende der Bewegung ab.

Aus der vorherigen Konfiguration T2 und der neuen Konfiguration T4 wird die Währendbedingung für die Bewegung der Schraube berechnet, analog zu R1:

$$R2.R = Cylinder(R2.f(T2), R2.f(T4))$$

D.h. die Bewegung wird abgebrochen sobald die Schraube 12 sich weiter bewegt als die Bedienperson es vorgemacht hat.

Zusätzlich wird eine Währendbedingung für die Kraft, die der Schraubendreher 10 auf die Schraube 12 aufbringen soll, berechnet. Der Vorgang ist analog zu G3:

$$R3.R = Cube(R3.f(T4), R3.f(T5))$$

Aus den gleichen Konfigurationen wird eine Zielbedingung berechnet. D.h. die Bewegung ist erfolgreich, wenn das Drehmoment im Bereich der von der Bedienperson geteachten Drehmomente ist. Die Berechnung erfolgt analog zu R3, allerdings mit einer Drehmomentbedingungsfunktion:

$$G4.R = Cube(G4.f(T4), G4.f(T5))$$

Gemäß Fig. 10 bewegt die Bedienperson den Roboter 7 weg von der Schraube 12 zur Konfiguration T6. Aus der vorherigen Konfiguration T5 und aus der Konfiguration T6 wird eine Zielbedingung berechnet, analog zu G2:

$$G5.R = Cube(G5.f(T5), G5.f(T6))$$

D.h. der Roboter 7 wird eine relative Bewegung nach oben machen, die der Entfernung von T5 nach T6 entspricht. Damit rückt der Roboter 7 sicher ein Stück von der Schraube 12 ab.

Fig. 11 zeigt in einer schematischen Ansicht eine beispielhafte Bedingungsregion für eine Kraftbedingungsfunktion einer Zielbedingung für ein Ausführungsbeispiel eines erfindungsgemäßen Verfahrens oder Systems.

Fig. 11 ist analog zum Aufzeichnungsschritt aus Fig. 8 zur Berechnung von

$$G3.R = Cube(G3.f(T2), G3.f(T3))$$

auf Basis der Konfigurationen T2 und T3. In den Konfigurationen T2 und T3 sind alle relevanten Informationen über den Roboter 7 zum Zeitpunkt des Teachings gespeichert, also auch gemessene Kraftwerte. Im Lernmodul ist für die Zielbedingung G3 die Funktion f und Bedingungsregion R hinterlegt mit noch zu bestimmenden freien Parametern. f ist hier eine Kraftbedingungsfunktion definiert als die gemessene Kraft als 3-dimensionaler Vektor (fx fy fz) gemessen im Tool-Center-Point (TCP), hier am Endpunkt des Schraubendrehers 10, relativ zu einem Referenzkoordinatensystem F1 (hier gleich Tool-Center-Point). Die zwei Werte von f für T2 und T3 werden berechnet, nämlich f(T2) und f(T3).

Die Bedingungsregion R ist in diesem Beispiel vom Bedingungsregionstyp: Sphere, d.h. eine Kugel mit Mittelpunkt M und Radius. Sie wird mit der Funktion Sphere() aus den zwei Werten der Bedingungsfunktion in T2 und T3 berechnet. Der berechnete Radius entspricht damit genau der Abweichung vom Mittelwert der geteachten Kraftwerte, die der Roboter selbst bei der Regelung zulassen kann. Damit kann die Bedienperson durch geeignete Konfigurationen die Robustheit der Ausführung erhöhen.

Fig. 12 zeigt ein Beispiel einer grafischen Anleitung 14 für eine Bedienperson bzw. einen Benutzer zur Erzeugung von zu teachenden bzw. aufzuzeichnenden Konfigurationen gemäß einem Ausführungsbeispiel eines erfindungsgemäßen Verfahrens oder Systems. Im Konkreten ist ein Beispiel für eine grafische Anleitung der Bedienperson/des Benutzers im Teach-Prozess dargestellt. Die Bedienperson bekommt prototypische Beispiele für zu teachende bzw. aufzuzeichnende Konfigurationen in ähnlichen Anwendungen (in 2D oder 3D) dargestellt und wird, vorzugsweise schrittweise, durch den Initialisierungsprozess geleitet.

Fig. 13 zeigt in einer schematischen Ansicht den Ablauf eines Initialisierungsprozesses bzw. eines Teach-Prozesses mittels eines Lernmoduls zur Erzeugung der Parameter für eine Bewegungsschablone gemäß einem Ausführungsbeispiel eines erfindungsgemäßen Verfahrens oder Systems. Fig. 13 umfasst die Darstellung des Ablaufs des Lernmoduls für eine Bewegungsschablone, die eine Spiralsuche ausführt. Das Ziel ist es einen gegriffenen Gegenstand 15 in ein Loch 16 zu stecken. Falls die Lage des Lochs 16 nur ungenau bekannt ist, muss das Loch 16 zuerst gesucht werden. Hierfür wird die Bewegungsschablone Spiralsuche eingesetzt. Bei der Spiralsuche kontaktiert der Roboter mit dem Gegenstand 15 die ebene Fläche 17, in der sich das Loch 16 befindet, wozu das bereits beschriebene Ausführungsmodul MoveToContact eingesetzt wird. Bei Kontakt führt der Roboter eine spiralförmige Bewegung 18 durch und übt dabei Kraft auf die Oberfläche aus. Falls die Spirale über das Loch 16 verläuft, rutsch der Gegenstand 15 in das Loch 16. Die Bewegung wird beendet, sobald der Gegenstand 15 um mindestens min und maximal max Millimeter in das Loch 16 gerutscht ist, was durch eine Zielbedingung repräsentiert wird.

a) Die Bedienperson demonstriert nacheinander 4 Konfigurationen, die eine Region um das Loch 16 markieren. Die Bedienperson demonstriert drei weitere Konfigurationen, die einen Bereich markieren, in den der Gegenstand 15 in das Loch 16 bewegt werden soll (siehe Fig. 13a).

b) Aus den ersten vier Konfigurationen werden eine Während- und zwei Zielbedingungen generiert für MoveToContact, analog zu Fig. 2. Aus der erzeugten Zielbedingung mit Bedingungsregionstyp Würfel (siehe Fig. 13 b) wird schrittweise eine spiralförmige Bewegung generiert: es werden die zwei Raumrichtungen mit der größten Ausdehnung berechnet, zum Beispiel unter Verwendung der Hauptkomponentenanalyse. Es wird unter Verwendung eines Algorithmus zur Erzeugung einer Spirale, zum Beispiel Archimedische Spirale, eine Spirale erzeugt und skaliert, so dass diese innerhalb der zwei größten Ausdehnungen liegt (siehe Fig. 13d)

c) Aus den letzten zwei Konfigurationen wird eine Zielbedingung vom Typ Lagebedingungsfunktion und Bedingungsregionstyp Cylinder berechnet (analog zu Fig. 9), Fig. 13c

d) Der Roboter bewegt sich auf der Spirale und bricht die Bewegung erfolgreich ab, falls die Zielbedingung gemäß Fig. 13c erfüllt ist, d.h. der Gegenstand ist ins Loch gerutscht.

Hinsichtlich weiterer vorteilhafter Ausgestaltungen des erfindungsgemäßen Verfahrens bzw. des erfindungsgemäßen Systems wird zur Vermeidung von Wiederholungen auf den allgemeinen Teil der Beschreibung sowie auf die beigefügten Patentansprüche verwiesen.

Schließlich sei ausdrücklich darauf hingewiesen, dass die voranstehend beschriebenen Ausführungsbeispiele des erfindungsgemäßen Verfahrens bzw. des erfindungsgemäßen Systems lediglich zur Erörterung der beanspruchten Lehre dienen, diese jedoch nicht auf die Ausführungsbeispiele einschränken.

**Bezugszeichenliste**

| | |
|---|---|
| 1 | Roboterprogramm |
| 2 | Bewegungsschablone |
| 3 | Ausführungsmodul |
| 4 | Ausführungsmodul |
| 5 | Lernmodul |
| 6 | Bedienperson |
| 7 | Roboter |
| 8 | Computer |
| 9 | Sensor |
| 10 | Schraubendreher |
| 11 | Robotersteuerung |
| 12 | Schraube |
| 13 | Werkstück |
| 14 | Grafische Anleitung |
| 15 | Gegenstand |
| 16 | Loch |
| 17 | Fläche |
| 18 | Spiralförmige Bewegung |
| M | Mittelpunkt |
| F1 | Referenzkoordinatensystem |
| PA1 - PA14 | Programmanweisung |
| TS1 - TS6 | Teilschritt |

**Patentansprüche**

1. Verfahren zur Programmierung eines Roboters (7), insbesondere eines Roboters (7) umfassend einen Roboterarm, wobei, vorzugsweise in einem Roboterprogramm (1), mit einer vordefinierten Bewegungsschablone (2) eine auszuführende Roboterbewegung eingerichtet wird,
wobei die Bewegungsschablone (2) aus einer mehrere Bewegungsschablonen umfassenden Datenbank selektiert wird,
**dadurch gekennzeichnet, dass** die Bewegungsschablone (2) ein oder mehrere parametrierbare Ausführungsmodule (3, 4) und mindestens ein Lernmodul (5) umfasst,
wobei das Ausführungsmodul bzw. die Ausführungsmodule (3, 4) zur Planung und/oder Durchführung der Roboterbewegung oder einer Teilbewegung der Roboterbewegung verwendet wird bzw. werden,
wobei in dem Lernmodul (5) ein maschinelles Lernverfahren implementiert ist,

wobei das Lernmodul (5) in einem Initialisierungsprozess, insbesondere in Form eines Teach-Prozesses, mehrere Konfigurationen des Roboters (7) aufzeichnet,
wobei das Lernmodul (5) basierend auf den aufgezeichneten Konfigurationen, unter Verwendung des maschinellen Lernverfahrens, Parameter für das Ausführungsmodul (3, 4) bzw. die Ausführungsmodule berechnet,
wobei die Parameter des Ausführungsmoduls bzw. der Ausführungsmodule (3, 4) Bedingungen umfassen, wobei auf Basis der Bedingungen die Roboterbewegung bzw. die Teilbewegung der Roboterbewegung geplant und/oder durchgeführt wird,
wobei die Bedingungen eine Bedingungsfunktion f und eine Bedingungsregion R umfassen, wobei die Bedingungsfunktion f eine Konfiguration k in einen vorzugsweise reellwertigen Vektorraum abbildet, wobei die Bedingungsregion R einer Teilmenge eines vorzugsweise reellwertigen Vektorraums entspricht, und wobei eine Bedingung für eine Konfiguration k erfüllt ist, wenn f(k) in R liegt, und
wobei als Typ für eine Bedingungsregion R ein achsausgerichteter Würfel, ein orientierter Würfel, ein Zylinder, ein Kegel, eine Kugel, eine Konvexe Hülle, ein CAD-Modell, eine Veroderung, eine Verundung und/oder eine Produktbildung verwendet wird,
wobei die Veroderung, Verundung und Produktbildung mindestens zwei Bedingungsregionen zu einer einzelnen Bedingungsregion kombinieren.

**2.** Verfahren nach Anspruch 1, **dadurch gekennzeichnet, dass** als Typ für eine Bedingungsfunktion f einer oder mehrere der folgenden Typen verwendet wird:

- Gelenkwinkel, -geschwindigkeit und/oder -beschleunigung des Roboters (7) oder eines Endeffektors, insbesondere eines Greifers, des Roboters (7);
- Position, Orientierung und/oder Lage eines Tool-Center-Points des Roboters (7) relativ zu einem Koordinatensystem;
- Geschwindigkeit, Winkelgeschwindigkeit und/oder Twist gemessen in einem Tool-Center-Point relativ zu einem Koordinatensystem;
- Kraft, Drehmoment und/oder Wrench gemessen in einem Tool-Center-Point relativ zu einem Koordinatensystem;
- Kollisionsfreiheit, Distanzbetrag und/oder Distanzvektor von einem CAD-Modell zu einem weiteren CAD-Modell;
- Griffbewertung von einem Endeffektor, insbesondere eines Greifers, des Roboters (7) und einem CAD-Modell.

**3.** Verfahren nach Anspruch 1 oder 2, **dadurch gekennzeichnet, dass** die Parameter des Ausführungsmoduls bzw. der Ausführungsmodule (3, 4) Währendbedingungen als Bedingungen umfassen, wobei eine Währendbedingung eine zeitabhängige Bedingung ist, die für ein vorgebbares Intervall von Zeitpunkten eine zu erfüllende Bedingung definiert.

**4.** Verfahren nach einem der Ansprüche 1 bis 3, **dadurch gekennzeichnet, dass** die Parameter des Ausführungsmoduls bzw. der Ausführungsmodule (3, 4) Zielbedingungen als Bedingungen umfassen, wobei eine Zielbedingung eine Bedingung ist, die für eine obere Intervallgrenze eines/des vorgebbaren Intervalls von Zeitpunkten eine zu erfüllende Bedingung definiert.

**5.** Verfahren nach einem der Ansprüche 1 bis 4, **dadurch gekennzeichnet, dass** das Ausführungsmodul bzw. die Ausführungsmodule (3, 4) unter Einhaltung eines Regelungsalgorithmus die Roboterbewegung bzw. eine Teilbewegung der Roboterbewegung so adaptiert/adaptieren, dass die Währendbedingungen eingehalten werden.

**6.** Verfahren nach einem der Ansprüche 1 bis 5, **dadurch gekennzeichnet, dass** bei Erfüllung der Zielbedingungen die Roboterbewegung bzw. eine Teilbewegung der Roboterbewegung erfolgreich beendet wird.

**7.** Verfahren nach einem der Ansprüche 1 bis 6, **dadurch gekennzeichnet, dass** basierend auf den Bedingungen, insbesondere basierend auf den Während- und/oder Zielbedingungen, für das Ausführungsmodul bzw. für die Ausführungsmodule (3, 4) der Bewegungsschablone (2), vorzugsweise unter Verwendung eines Bahnplanungsalgorithmus, eine Bewegungsbahn berechnet wird.

**8.** Verfahren nach einem der Ansprüche 1 bis7, **dadurch gekennzeichnet, dass** das Ausführungsmodul bzw. die Ausführungsmodule (3, 4) mittels Kompilierung auf ein Zielsystem, insbesondere auf eine Robotersteuerung (11), abgebildet wird bzw. werden.

9. Verfahren nach einem der Ansprüche 1 bis 8, **dadurch gekennzeichnet, dass** in dem Initialisierungsprozess die aufzuzeichnenden Konfigurationen mittels unterschiedlicher Schnittstellen durch einen Benutzer erzeugbar sind, insbesondere mittels manuellen Führens des Roboters (7) durch den Benutzer, mittels Mausinteraktion in einer 3D-Simulationsumgebung und/oder mittels weiterer geeigneter Steuermittel, und/oder
wobei in dem Initialisierungsprozess eine Interaktion mit einem Benutzer erfolgt, wobei Rückfragen bzw. Anweisungen an den Benutzer zur Erzeugung der aufzuzeichnenden Konfigurationen gestellt werden.

10. Verfahren nach einem der Ansprüche 1 bis 9, **dadurch gekennzeichnet, dass** das Ausführungsmodul bzw. die Ausführungsmodule (3, 4) derart hierarchisch aufgebaut ist/sind, dass ein Ausführungsmodul als primitiver Operator ausgebildet ist oder aus mindestens einem Ausführungsmodul und/oder mindestens einer Bewegungsschablone (2) gebildet wird.

11. System zur Programmierung eines Roboters, insbesondere eines Roboters (7) umfassend einen Roboterarm, insbesondere zur Durchführung eines Verfahrens nach einem der Ansprüche 1 bis 10, wobei, vorzugsweise in einem Roboterprogramm (1), mit einer vordefinierten Bewegungsschablone (2) eine auszuführende Roboterbewegung eingerichtet wird,
wobei die Bewegungsschablone (2) aus einer mehrere Bewegungsschablonen umfassenden Datenbank selektierbar ist,
**dadurch gekennzeichnet, dass** die Bewegungsschablone (2) ein oder mehrere parametrierbare Ausführungsmodule (3, 4) und mindestens ein Lernmodul (5) umfasst,
wobei das Ausführungsmodul bzw. die Ausführungsmodule (3, 4) zur Planung und/oder Durchführung der Roboterbewegung oder einer Teilbewegung der Roboterbewegung verwendet wird bzw. werden,
wobei in dem Lernmodul (5) ein maschinelles Lernverfahren implementiert ist,
wobei das Lernmodul (5) in einem Initialisierungsprozess, insbesondere in Form eines Teach-Prozesses, mehrere Konfigurationen des Roboters (7) aufzeichnet,
wobei das Lernmodul (5) basierend auf den aufgezeichneten Konfigurationen, unter Verwendung des maschinellen Lernverfahrens, Parameter für das Ausführungsmodul bzw. die Ausführungsmodule (3, 4) berechnet,
wobei die Parameter des Ausführungsmoduls bzw. der Ausführungsmodule (3, 4) Bedingungen umfassen, wobei auf Basis der Bedingungen die Roboterbewegung bzw. die Teilbewegung der Roboterbewegung planbar und/oder durchführbar ist, und
wobei die Bedingungen eine Bedingungsfunktion f und eine Bedingungsregion R umfassen, wobei die Bedingungsfunktion f eine Konfiguration k in einen vorzugsweise reellwertigen Vektorraum abbildet, wobei die Bedingungsregion R einer Teilmenge eines vorzugsweise reellwertigen Vektorraums entspricht, und wobei eine Bedingung für eine Konfiguration k erfüllt ist, wenn f(k) in R liegt,
wobei als Typ für eine Bedingungsregion R ein achsausgerichteter Würfel, ein orientierter Würfel, ein Zylinder, ein Kegel, eine Kugel, eine Konvexe Hülle, ein CAD-Modell, eine Veroderung, eine Verundung und/oder eine Produktbildung verwendet wird,
wobei die Veroderung, Verundung und Produktbildung mindestens zwei Bedingungsregionen zu einer einzelnen Bedingungsregion kombinieren.

12. Computerprogrammprodukt mit Programmcode, der auf einem maschinenlesbaren Träger gespeichert ist und ein Verfahren zur Programmierung eines Roboters (7) nach einem der Ansprüche 1 bis 10 bereitstellt und/oder ausführt.

## Claims

1. Method for programming a robot (7), in particular a robot (7) comprising a robot arm, wherein, preferably in a robot programme (1), a robot movement which is intended to be carried out is configured in a predefined movement template (2),
wherein the movement template (2) is selected from a database which comprises a plurality of movement templates,
**characterised in that** the movement template (2) comprises one or more execution modules (3, 4) which can be parameterised and at least one learning module (5),
wherein the execution module or the execution modules (3, 4) is/are used to plan and/or carry out the robot movement or a part-movement of the robot movement,
wherein a machine learning method is implemented in the learning module (5),
wherein the learning module (5) in an initialisation process, in particular in the form of a Teach process, records several configurations of the robot (7),
wherein the learning module (5) based on the recorded configurations, using the machine learning method, calculates parameters for the execution module (3, 4) or the execution modules,
wherein the parameters of the execution module or the execution modules (3, 4) comprise conditions, wherein the robot movement or the part-movement of the robot movement is planned and/or carried out based on the conditions, wherein the conditions comprise a condition function f and a condition region R, wherein the condition function f maps a configuration k in a preferably real-valued vector space, wherein the condition region R corresponds to a subset of a preferably real-valued vector space, and wherein a condition for a configuration k is satisfied, if f(k) is located in R, and
wherein an axially orientated cube, an orientated cube, a cylinder, a cone, a sphere, a convex hull, a CAD model, an OR function, an AND function and/or a product formation is used as a type for a condition region R,
wherein the OR function, the AND function and the product formation combine at least two condition regions to one single condition region.

2. Method according to claim 1, **characterised in that** one or more of the following types is used as a type for a condition function f:

- articulation angle, speed and/or acceleration of the robot (7) or an end effector, in particular of a gripper, of the robot (7);
- position, orientation and/or situation of a tool-centre-point of the robot (7) relative to a coordinate system;
- speed, angular speed and/or twist measured in a tool-centre-point relative to a coordinate system;
- force, torque and/or wrench measured in a tool-centre-point relative to a coordinate system;
- collision freedom, distance value and/or distance vector from one CAD model to another CAD model;
- gripping evaluation by an end effector, in particular of a gripper, of the robot (7) and a CAD model.

3. Method according to claim 1 or 2, **characterised in that** the parameters of the execution module or the execution modules (3, 4) comprise while conditions as conditions, wherein a while condition is a time-dependent condition which defines a condition which is intended to be fulfilled for a predeterminable range of times.

4. Method according to any one of claims 1 to 3,
**characterised in that** the parameters of the execution module or the execution modules (3, 4) comprise target conditions as conditions, wherein a target condition is a condition which defines a condition which is intended to be fulfilled for an upper range limit of a/the predeterminable range of times.

5. Method according to any of claims 1 to 4, **characterised in that** the execution module or the execution modules (3, 4) whilst complying with a control algorithm adapt(s) the robot movement or a part-movement of the robot movement in such a manner that the while conditions are complied with.

6. Method according to any of claims 1 to 5,
**characterised in that**, when the target conditions are met, the robot movement or a part-movement of the robot movement is successfully ended.

7. Method according to any one of claims 1 to 6,
**characterised in that** based on the conditions, in particular based on the while and/or target conditions, a movement path is calculated for the execution module or the execution modules (3, 4) of the movement template (2), preferably using a path planning algorithm.

8. Method according to any one of claims 1 to 7,
**characterised in that** the execution module or the execution modules (3, 4) is/are mapped to a target system, in particular on a robot control system (11), by means of compiling.

9. Method according to any one of claims 1 to 8,
**characterised in that** in the initialisation process the configurations to be recorded can be produced by a user by means of different interfaces, in particular by the user by manually guiding the robot (7), by means of mouse interaction in a 3D simulation environment and/or by means of other appropriate control means, and/or
wherein in the initialisation process an interaction with a user is carried out, wherein questions or instructions are passed to the user in order to produce the configurations which are intended to be recorded.

10. Method according to any one of claims 1 to 9,
**characterised in that** the execution module or the execution modules (3, 4) is/are constructed in such a hierarchical manner that an execution module is constructed as a primitive operator or is formed from at least one execution module and/or at least one movement template (2).

11. System for programming a robot, in particular a robot (7) comprising a robot arm, in particular for carrying out a method according to any one of claims 1 to 10, wherein, preferably in a robot programme (1), using a predefined movement template (2) a robot movement which is intended to be carried out is configured,
wherein the movement template (2) can be selected from a database which comprises a plurality of movement templates, **characterised in that** the movement template (2) comprises one or more parameterisable execution modules (3, 4) and at least one learning module (5),
wherein the execution module or the execution modules (3, 4) is/are used to plan and/or carry out the robot movement or a part-movement of the robot movement,
wherein a machine learning method is implemented in the learning module (5),
wherein the learning module (5) in an initialisation process, in particular in the form of a Teach process, records several configurations of the robot (7),
wherein the learning module (5) based on the recorded configurations, using the machine learning method, calculates parameters for the execution module or the execution modules (3, 4),
wherein the parameters of the execution module or the execution modules (3, 4) comprise conditions, wherein the robot movement or the part-movement of the robot movement is planned and/or carried out based on the conditions,
wherein the conditions comprise a condition function f and a condition region R, wherein the condition function f maps a configuration k in a preferably real-valued vector space, wherein the condition region R corresponds to a subset of a preferably real-valued vector space, and wherein a condition for a configuration k is satisfied, if f(k) is located in R, and
wherein an axially orientated cube, an orientated cube, a cylinder, a cone, a sphere, a convex hull, a CAD model, an OR function, an AND function and/or a product formation is used as a type for a condition region R,
wherein the OR function, the AND function and the product formation combine at least two condition regions to one single condition region.

12. Computer programme product having programme code which is stored on a machine-readable carrier and which provides and/or carries out a method for programming a robot (7) according to any one of claims 1 to 10.

## Revendications

1. Procédé de programmation d’un robot (7), plus particulièrement d’un robot (7) comprenant un bras de robot, un mouvement de robot à effectuer étant configuré, de préférence dans un programme de robot (1), avec un gabarit de mouvement (2) prédéfini,
le gabarit de mouvement (2) étant sélectionné dans une base de données comprenant plusieurs gabarits de mouvement,
**caractérisé en ce que** le gabarit de mouvement (2) comprend un ou plusieurs modules d’exécution (3, 4) paramétrables et au moins un module d’apprentissage (5),
le module d’exécution ou les modules d’exécution (3, 4) étant utilisés pour la planification et/ou l’exécution du mouvement du robot ou d’un mouvement partiel du mouvement du robot,
un processus d’apprentissage mécanique étant implémenté dans le module d’apprentissage (5),
le module d’apprentissage (5) enregistrant, dans le cadre d’un processus d’initialisation, plus particulièrement sous la forme d’un processus d’apprentissage, plusieurs configurations du robot (7),
le module d’apprentissage (5) calculant, sur la base des configurations enregistrées, à l’aide du procédé d’apprentissage mécanique, des paramètres pour le module d’exécution (3, 4) ou les modules d’exécution,
les paramètres du module d’exécution ou des modules d’exécution (3, 4) comprenant des conditions, moyennant quoi, sur la base des conditions, le mouvement du robot ou le mouvement partiel du mouvement du robot est planifié et/ou effectué,
les conditions comprenant une fonction conditionnelle f et une région conditionnelle R, la fonction conditionnelle f représentant une configuration k dans un espace vectoriel, de préférence à valeurs réelles, la région conditionnelle R correspondant à une partie d’un espace vectoriel, de préférence à valeurs réelles et une condition pour une configuration k étant remplie lorsque f(k) se trouve dans R,
un cube aligné axialement, un cube orienté, un cylindre, un cône, une sphère, une enveloppe convexe, un modèle CAO, une fonction logique OU, une fonction logique ET et/ou la formation d’un produit étant utilisé en tant que type pour une région conditionnelle R,
la fonction logique OU, la fonction logique ET et la formation du produit combinant au moins deux régions conditionnelles en une seule région conditionnelle.

2. Procédé selon la revendication 1, **caractérisé en ce que**, en tant que type pour une fonction de condition f, un ou plusieurs des types suivants sont utilisés :

- angle, vitesse et/ou accélération d'articulation du robot (7) ou d'un effecteur d'extrémité, plus particulièrement d'un préhenseur, du robot (7) ;
- position, orientation et/ou position d'un point de centre d'outil du robot (7) par rapport à un système de coordonnées ;
- vitesse, vitesse angulaire et/ou torsion mesurée dans un point de centre d'outil par rapport à un système de coordonnées ;
- force, couple et/ou mouvement violent mesuré dans un point de centre d'outil par rapport à un système de coordonnées ;
- absence de collision, distance et/ou vecteur de distance entre un modèle CAO et un autre modèle CAO ;
- évaluation de la préhension d'un effecteur d'extrémité, plus particulièrement d'un préhenseur, du robot (7) et d'un modèle CAO.

3. Procédé selon la revendication1 ou 2, **caractérisé en ce que** les paramètres du module d'exécution ou des modules d'exécution (3, 4) comprennent des conditions « pendant » en tant que conditions, une condition « pendant » étant une condition temporelle qui définit, pour un intervalle prédéterminé de moments, une condition à satisfaire.

4. Procédé selon l'une des revendications 1 à 3, **caractérisé en ce que** les paramètres du modules d'exécution ou des modules d'exécution (3, 4) comprennent des conditions cibles en tant que conditions, une condition cible étant une condition qui définit, pour une limite supérieure d'intervalle d'un / de l'intervalle prédéterminé de moments, une condition à satisfaire.

5. Procédé selon l'une des revendications 1 à 4, **caractérisé en ce que** le module d'exécution ou les modules d'exécution (3, 4) adaptent, en respectant un algorithme de régulation, le mouvement du robot ou un mouvement partiel du mouvement du robot de façon à ce que les conditions « pendant » soient respectées.

6. Procédé selon l'une des revendications 1 à 5, **caractérisé en ce que**, lorsque les conditions cibles sont remplies, le mouvement du robot ou un mouvement partiel du mouvement du robot se termine avec succès.

7. Procédé selon l'une des revendications 1 à 6, **caractérisé en ce que**, sur la base des conditions, plus particulièrement sur la base des conditions « pendant » et/ou cibles, pour le module d'exécution ou pour les modules d'exécution (3, 4) du gabarit de mouvement (2), une trajectoire de mouvement est calculée, de préférence à l'aide d'un algorithme de planification de trajectoire.

8. Procédé selon l'une des revendications 1 à 7, **caractérisé en ce que** le module d'exécution ou les modules d'exécution (3, 4) sont représentés au moyen d'une compilation sur un système cible, plus particulièrement sur une commande de robot (11).

9. Procédé selon l'une des revendications 1 à 8, **caractérisé en ce que**, dans le processus d'initialisation, les configurations à enregistrer peuvent être générées au moyen de différentes interfaces par un utilisateur, plus particulièrement au moyen d'un guidage manuel du robot (7) par l'utilisateur, au moyen d'une interaction avec une souris dans un environnement de simulation 3D et/ou à l'aide d'autres moyens de commande appropriés et/ou
dans le processus d'initialisation, une interaction ayant lieu avec un utilisateur, des questions étant posées ou des instructions étant données à l'utilisateur pour la génération des configurations à enregistrer.

10. Procédé selon l'une des revendications 1 à 9, **caractérisé en ce que** le module d'exécution ou les modules d'exécution (3, 4) sont conçus de manière hiérarchique de façon à ce qu'un module d'exécution soit conçu comme un opérateur primitif ou soit constitué d'au moins un module d'exécution et/ou d'au moins un gabarit de mouvement (2).

11. Système de programmation d'un robot, plus particulièrement d'un robot (7) comprenant un bras de robot, plus particulièrement pour l'exécution d'un procédé selon l'une des revendications 1 à 10, un mouvement de robot à exécuter étant configuré, de préférence dans un programme de robot (1), avec un gabarit de mouvement (2) prédéfini, le gabarit de mouvement (2) pouvant être sélectionné dans une base de données comprenant plusieurs gabarits de mouvement,

**caractérisé en ce que** le gabarit de mouvement (2) comprend un ou plus modules d'exécution (3, 4) paramétrables et au moins un module d'apprentissage (5),
le module d'exécution ou les modules d'exécution (3, 4) étant utilisés pour la planification et/ou l'exécution du mouvement de robot ou un mouvement partiel du mouvement de robot,
un procédé d'apprentissage mécanique étant implémenté dans le module d'apprentissage (5),
le module d'apprentissage (5) enregistrant, dans un processus d'initialisation, plus particulièrement sous la forme d'un processus d'apprentissage, plusieurs configurations du robot (7),
le module d'apprentissage (5) calculant, sur la base des configurations enregistrées, de préférence à l'aide du procédé d'apprentissage mécanique, des paramètres pour le module d'exécution ou les modules d'exécution (3, 4),
les paramètres du module d'exécution ou des modules d'exécution (3, 4) comprenant des conditions, moyennant quoi, sur la base des conditions, le mouvement du robot ou le mouvement partiel du mouvement du robot est planifié et/ou effectué,
les conditions comprenant une fonction conditionnelle f et une région conditionnelle R, la fonction conditionnelle f représentant une configuration k dans un espace vectoriel, de préférence à valeurs réelles, la région conditionnelle R correspondant à une partie d'un espace vectoriel, de préférence à valeurs réelles et une condition pour une configuration k étant remplie lorsque f(k) se trouve dans R,
un cube aligné axialement, un cube orienté, un cylindre, un cône, une sphère, une enveloppe convexe, un modèle CAO, une fonction logique OU, une fonction logique ET et/ou la formation d'un produit étant utilisé en tant que type pour une région conditionnelle R,
la fonction logique OU, la fonction logique ET et la formation du produit combinant au moins deux régions conditionnelles en une seule région conditionnelle.

**12.** Produit de programme informatique avec code de programme stocké sur un support lisible par un ordinateur et qui met à disposition et/ou exécute un procédé de programmation d'un robot (7) selon l'une des revendications 1 à 10.

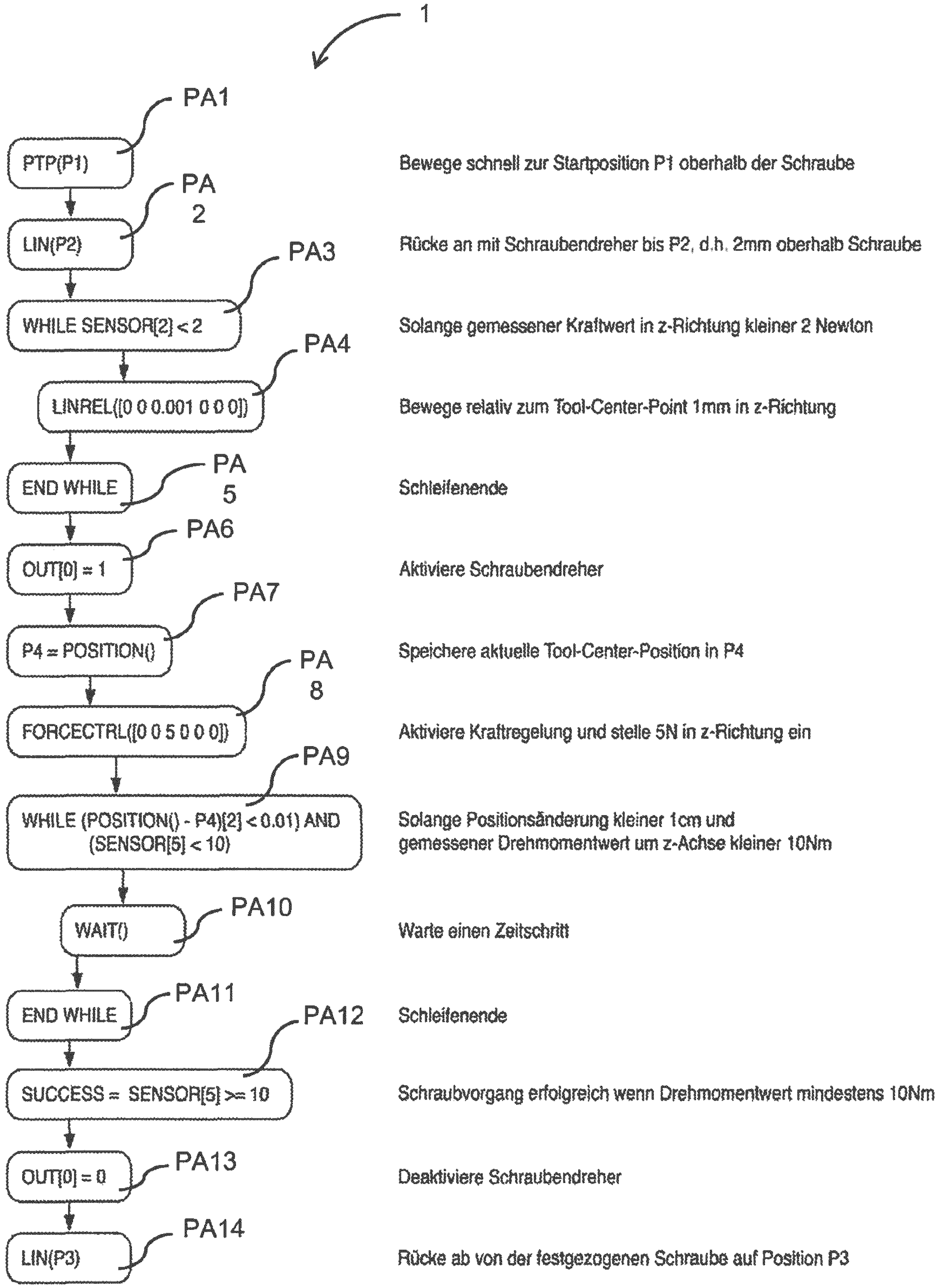
1
PA1
PTP(P1)
Bewege schnell zur Startposition P1 oberhalb der Schraube
PA 2
LIN(P2)
Rücke an mit Schraubendreher bis P2, d.h. 2mm oberhalb Schraube
PA3
WHILE SENSOR[2] < 2
Solange gemessener Kraftwert in z-Richtung kleiner 2 Newton
PA4
LINREL([0 0 0.001 0 0 0])
Bewege relativ zum Tool-Center-Point 1mm in z-Richtung
PA 5
END WHILE
Schleifenende
PA6
OUT[0] = 1
Aktiviere Schraubendreher
PA7
P4 = POSITION()
Speichere aktuelle Tool-Center-Position in P4
PA 8
FORCECTRL([0 0 5 0 0 0])
Aktiviere Kraftregelung und stelle 5N in z-Richtung ein
PA9
WHILE (POSITION() - P4)[2] < 0.01) AND (SENSOR[5] < 10)
Solange Positionsänderung kleiner 1cm und gemessener Drehmomentwert um z-Achse kleiner 10Nm
PA10
WAIT()
Warte einen Zeitschritt
PA11
END WHILE
Schleifenende
PA12
SUCCESS = SENSOR[5] >= 10
Schraubvorgang erfolgreich wenn Drehmomentwert mindestens 10Nm
PA13
OUT[0] = 0
Deaktiviere Schraubendreher
PA14
LIN(P3)
Rücke ab von der festgezogenen Schraube auf Position P3

Fig. 1

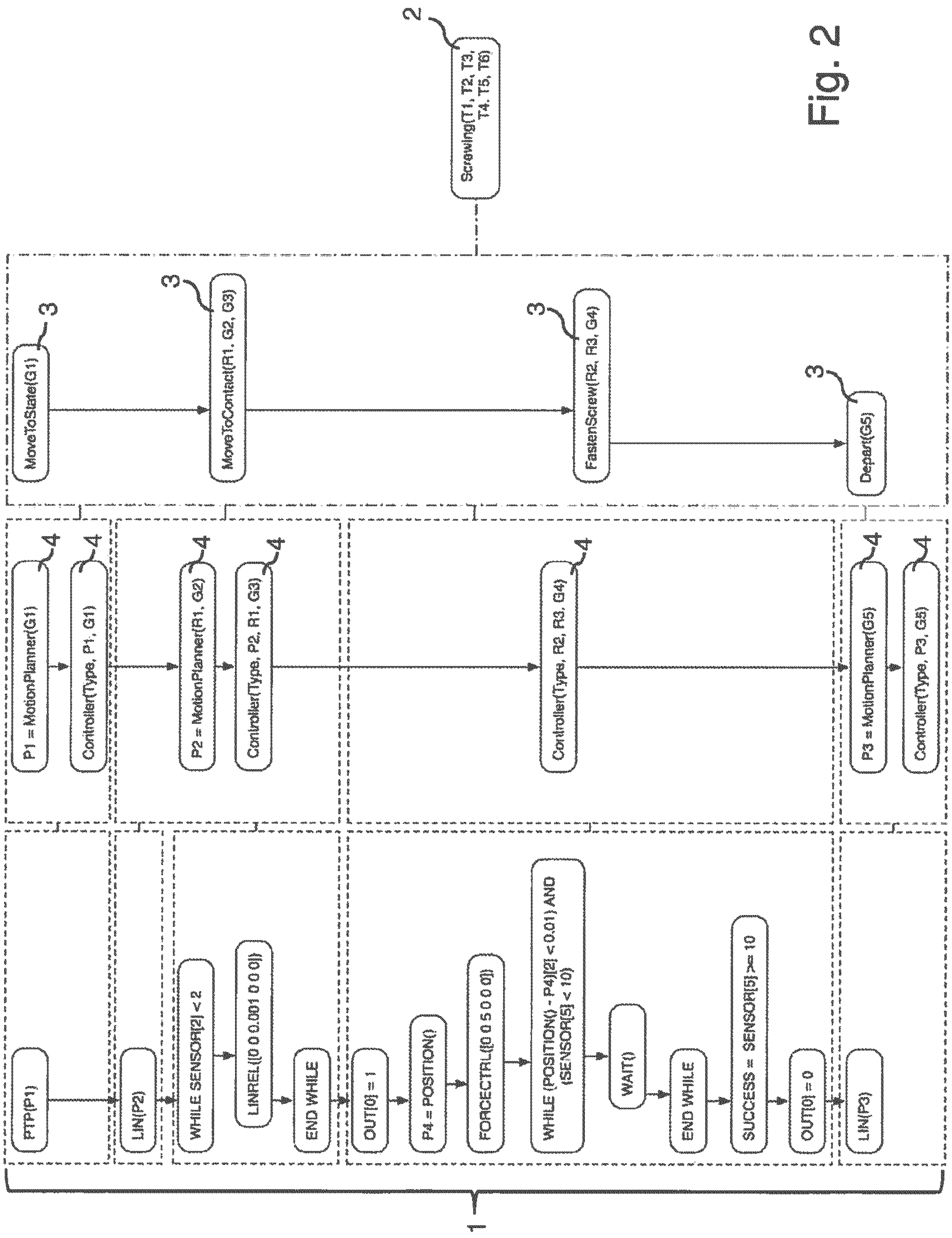

Screwing(T1, T2, T3, T4, T5, T6)
2
MoveToState(G1)
MoveToContact(R1, G2, G3)
FastenScrew(R2, R3, G4)
Depart(G5)
3
P1 = MotionPlanner(G1)
Controller(Type, P1, G1)
P2 = MotionPlanner(R1, G2)
Controller(Type, P2, R1, G3)
Controller(Type, R2, R3, G4)
P3 = MotionPlanner(G5)
Controller(Type, P3, G5)
4
PTP(P1)
LIN(P2)
WHILE SENSOR[2] < 2
LINREL([0 0 0.001 0 0 0])
END WHILE
OUT[0] = 1
P4 = POSITION()
FORCECTRL([0 0 5 0 0 0])
WHILE (POSITION() - P4)[2] < 0.01) AND (SENSOR[5] < 10)
WAIT()
END WHILE
SUCCESS = SENSOR[5] >= 10
OUT[0] = 0
LIN(P3)
1


Fig. 2

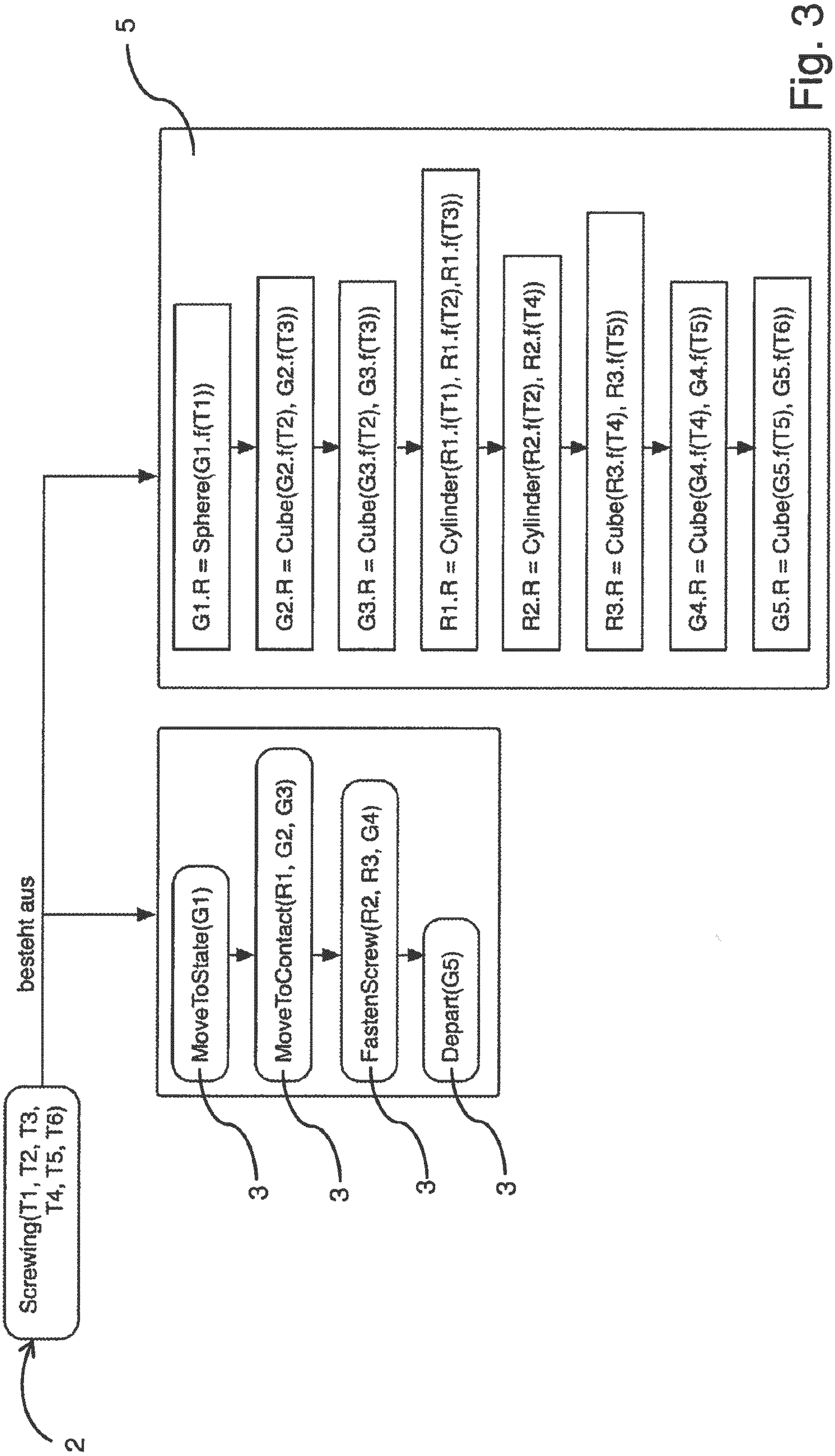

Screwing(T1, T2, T3, T4, T5, T6)
besteht aus
MoveToState(G1)
MoveToContact(R1, G2, G3)
FastenScrew(R2, R3, G4)
Depart(G5)
G1.R = Sphere(G1.f(T1))
G2.R = Cube(G2.f(T2), G2.f(T3))
G3.R = Cube(G3.f(T2), G3.f(T3))
R1.R = Cylinder(R1.f(T1), R1.f(T2),R1.f(T3))
R2.R = Cylinder(R2.f(T2), R2.f(T4))
R3.R = Cube(R3.f(T4), R3.f(T5))
G4.R = Cube(G4.f(T4), G4.f(T5))
G5.R = Cube(G5.f(T5), G5.f(T6))
2
3
3
3
3
5


Fig. 3

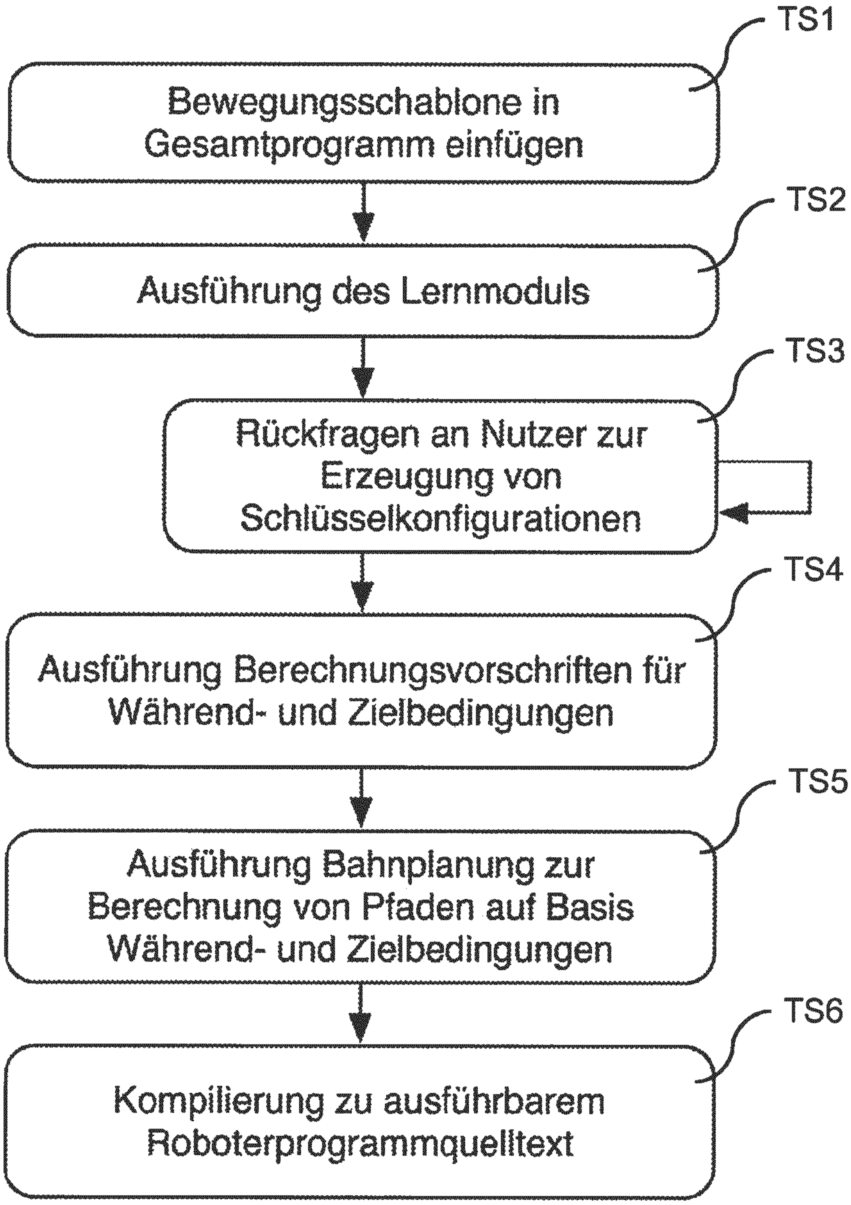
TS1
Bewegungsschablone in Gesamtprogramm einfügen
TS2
Ausführung des Lernmoduls
TS3
Rückfragen an Nutzer zur Erzeugung von Schlüsselkonfigurationen
TS4
Ausführung Berechnungsvorschriften für Während- und Zielbedingungen
TS5
Ausführung Bahnplanung zur Berechnung von Pfaden auf Basis Während- und Zielbedingungen
TS6
Kompilierung zu ausführbarem Roboterprogrammquelltext

Fig. 4

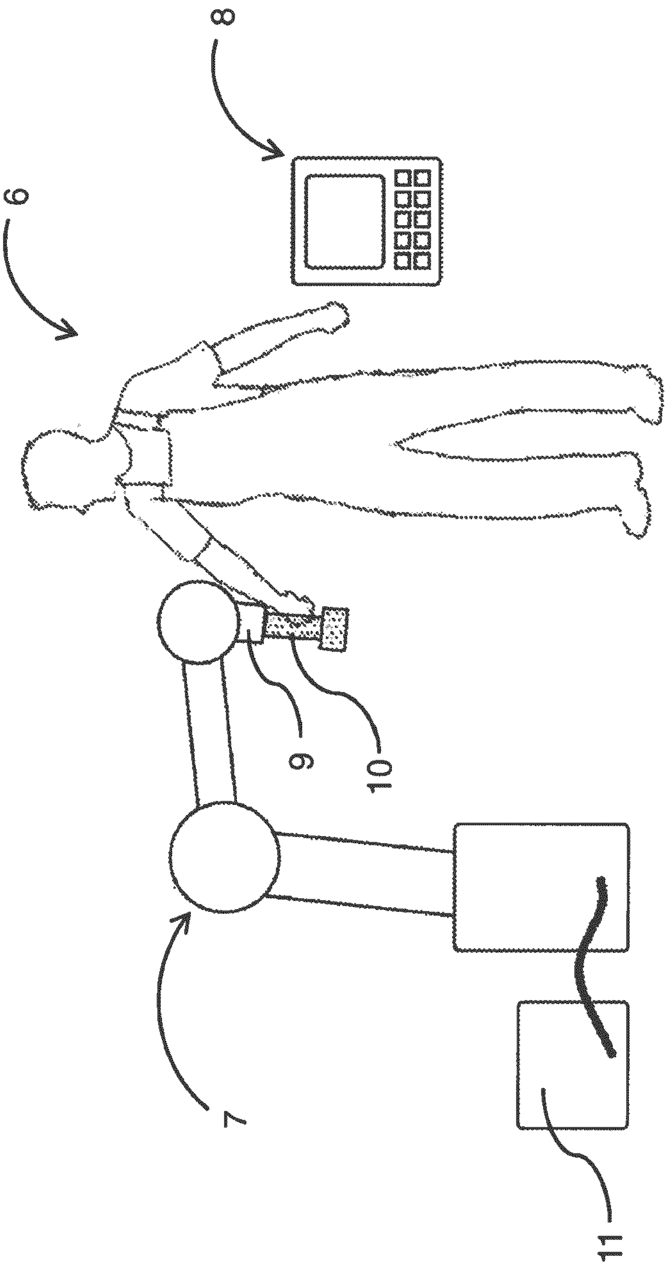


Fig. 5

Fig. 6

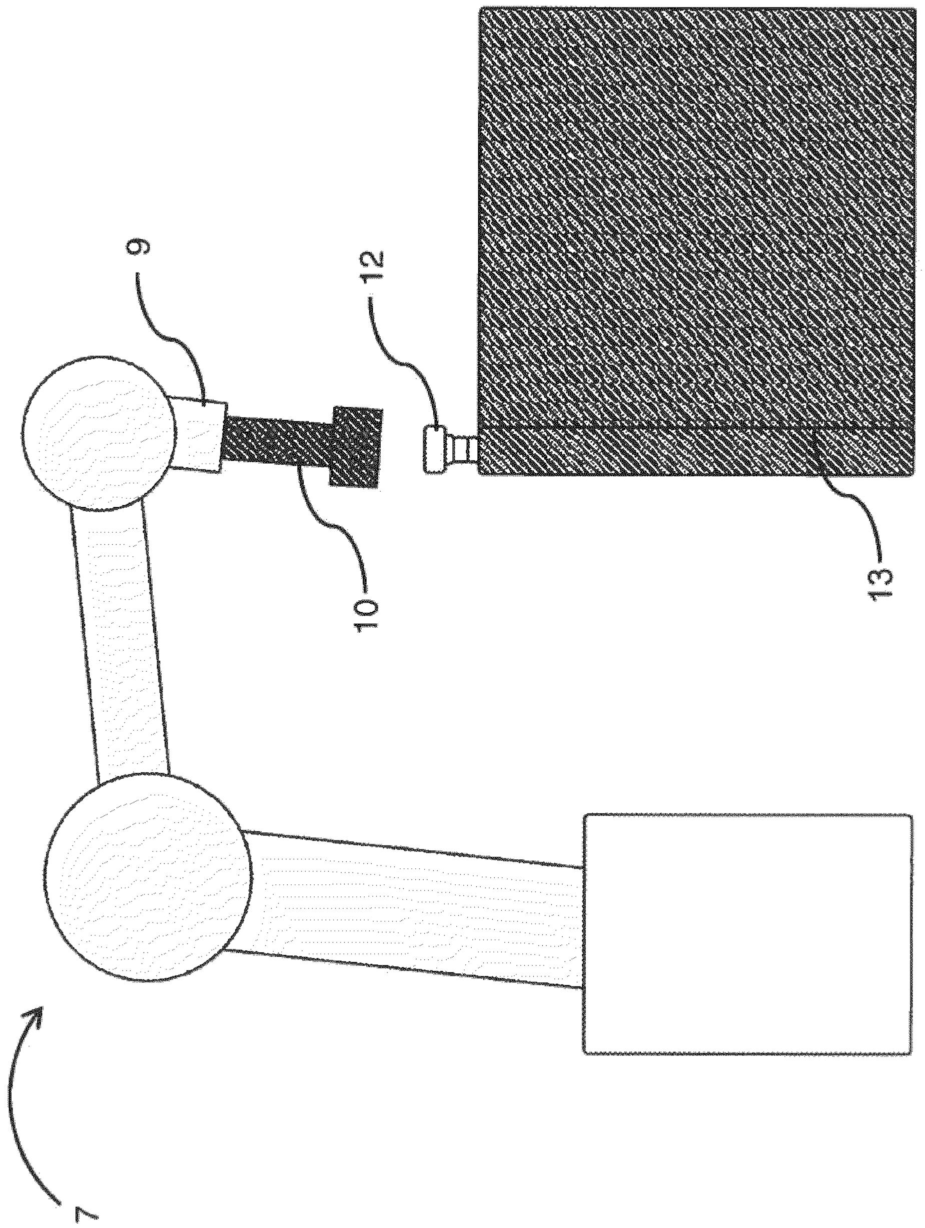

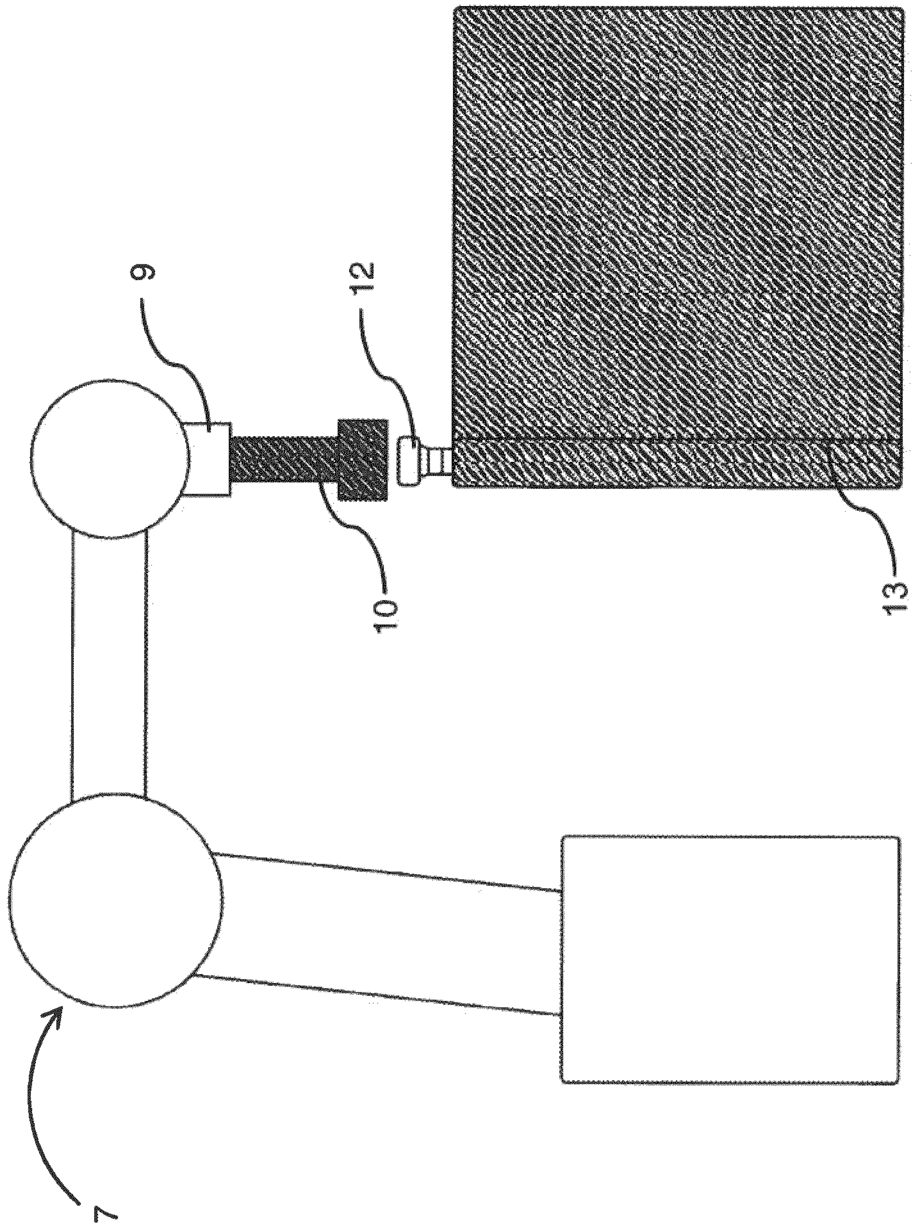


Fig. 7

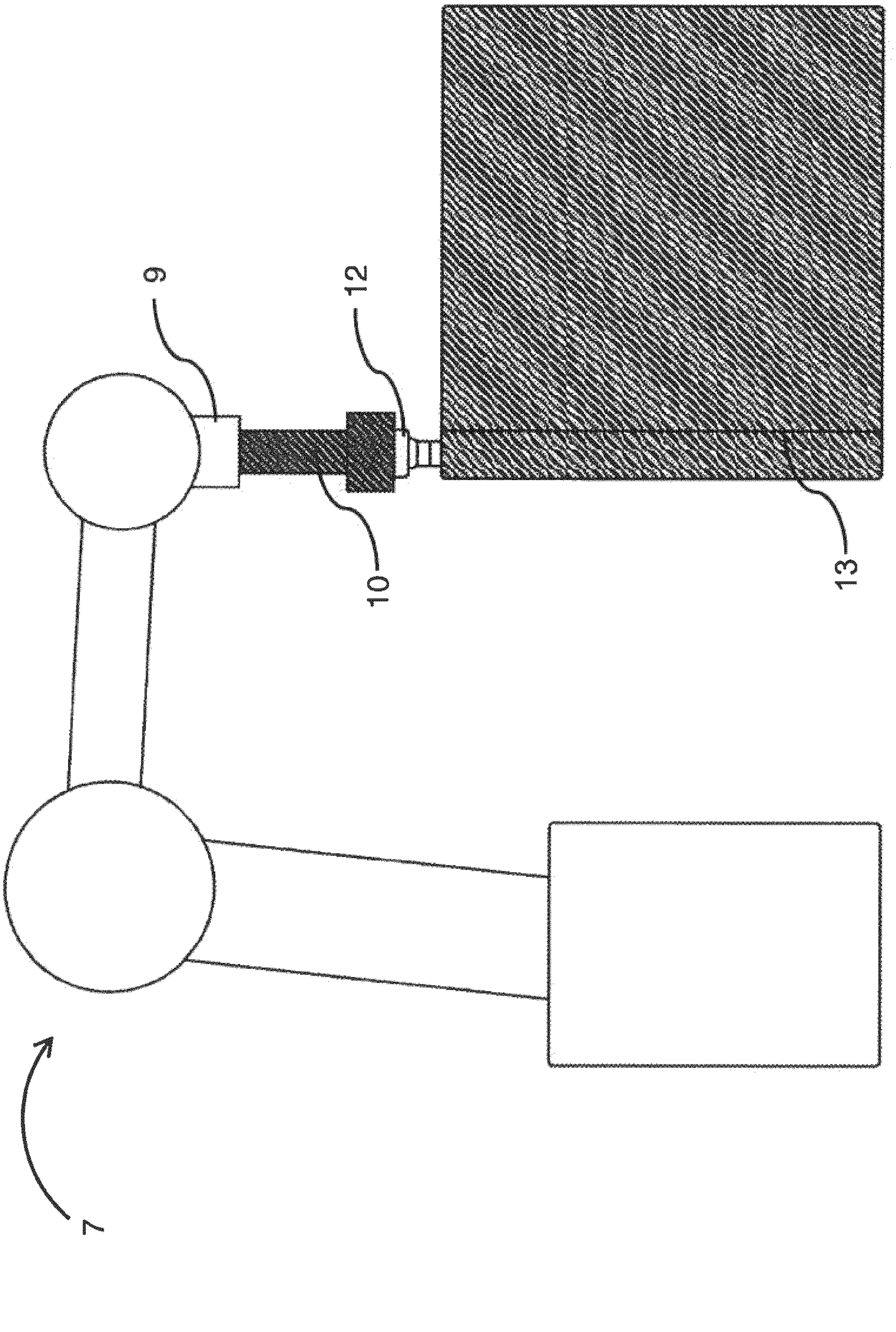


Fig. 8

Fig. 9

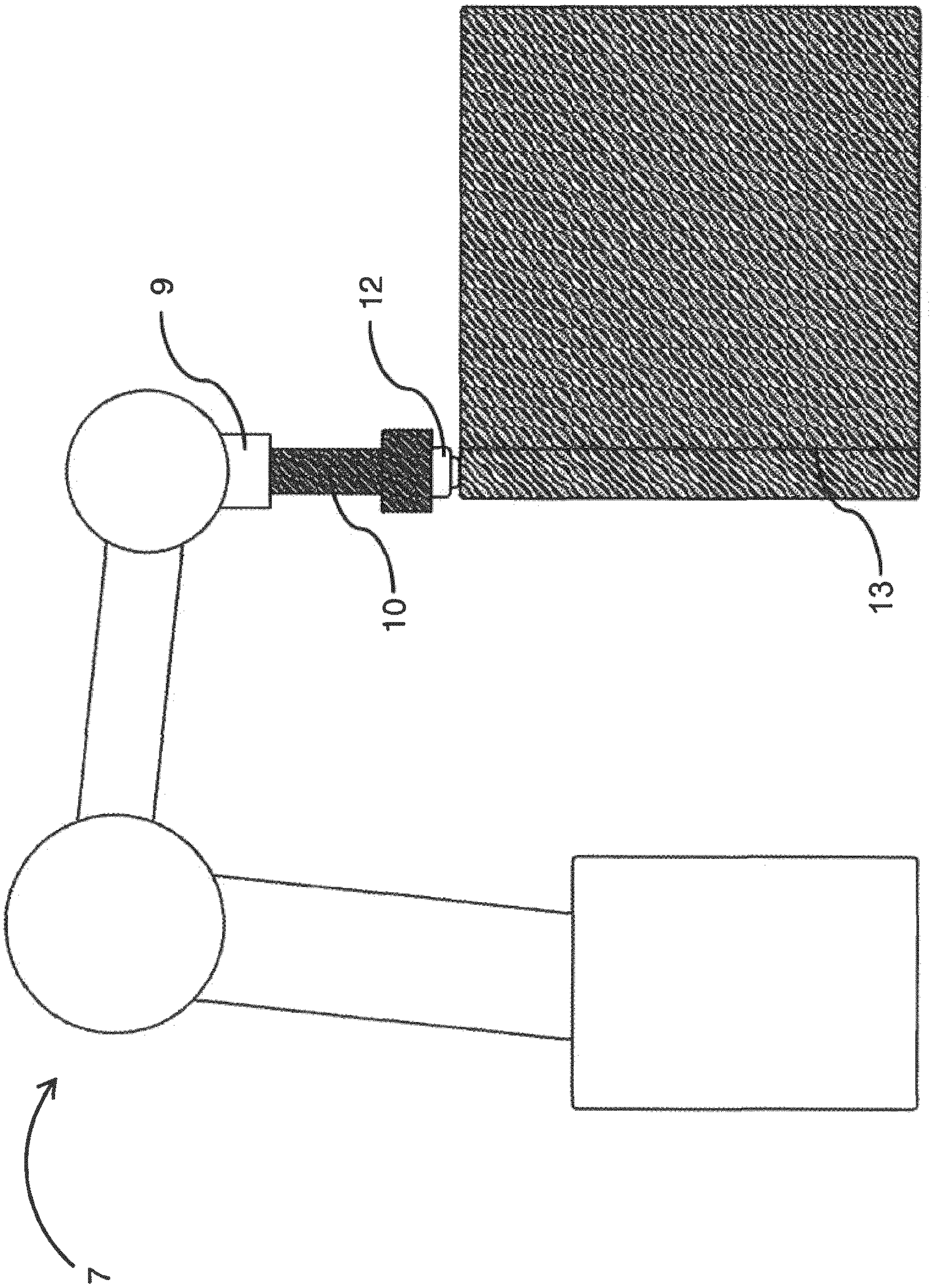

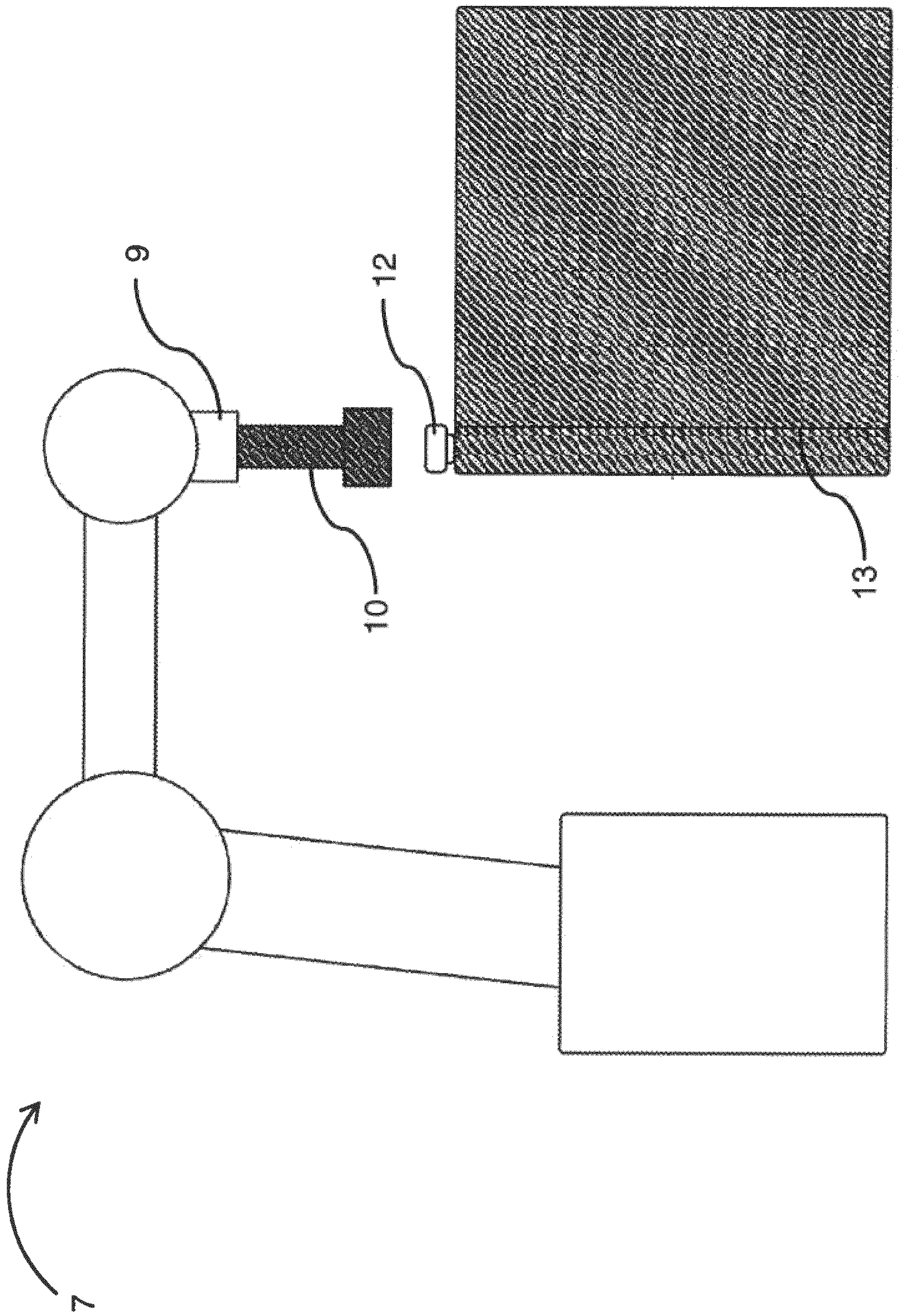


Fig. 10

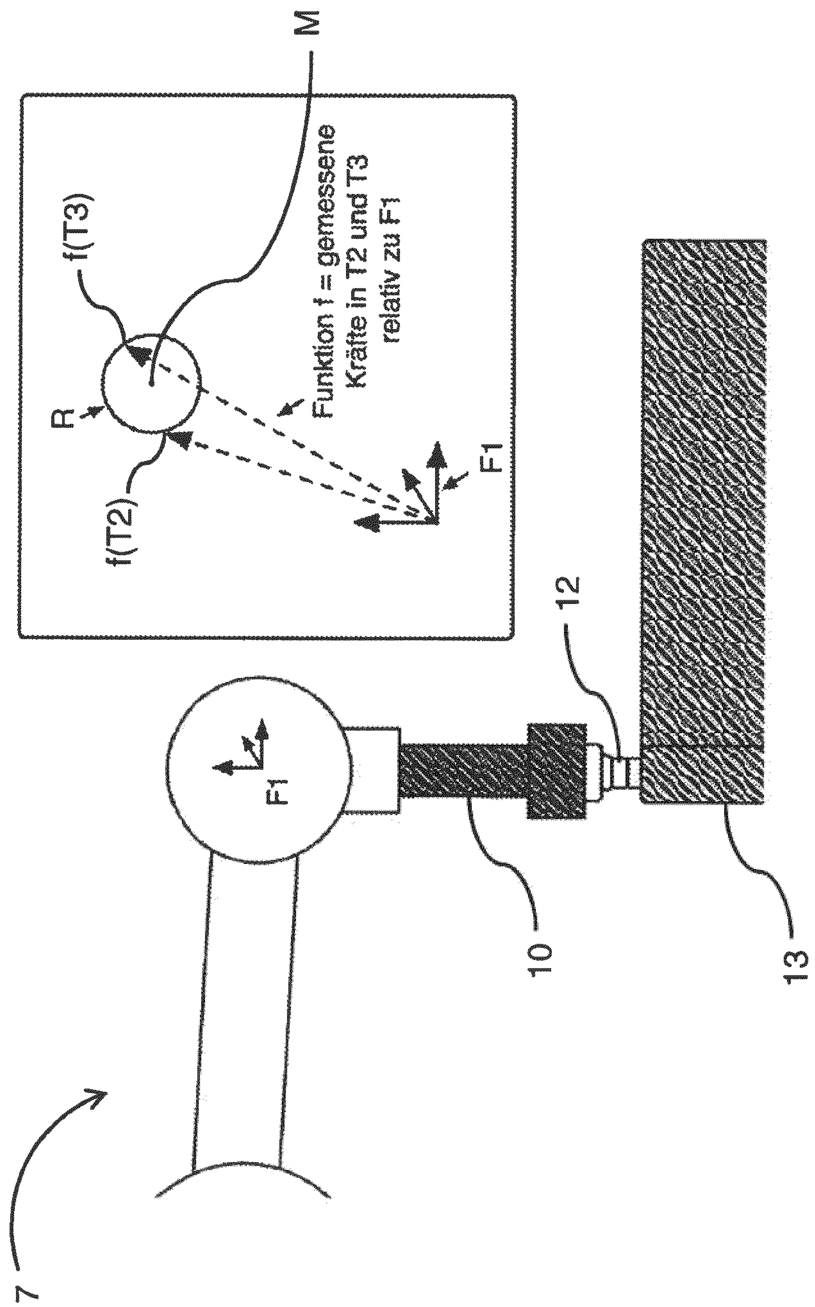
M
f(T3)
R
f(T2)
Funktion f = gemessene
Kräfte in T2 und T3
relativ zu F1
F1
F1
12
10
13
7

Fig. 11

Fig. 12

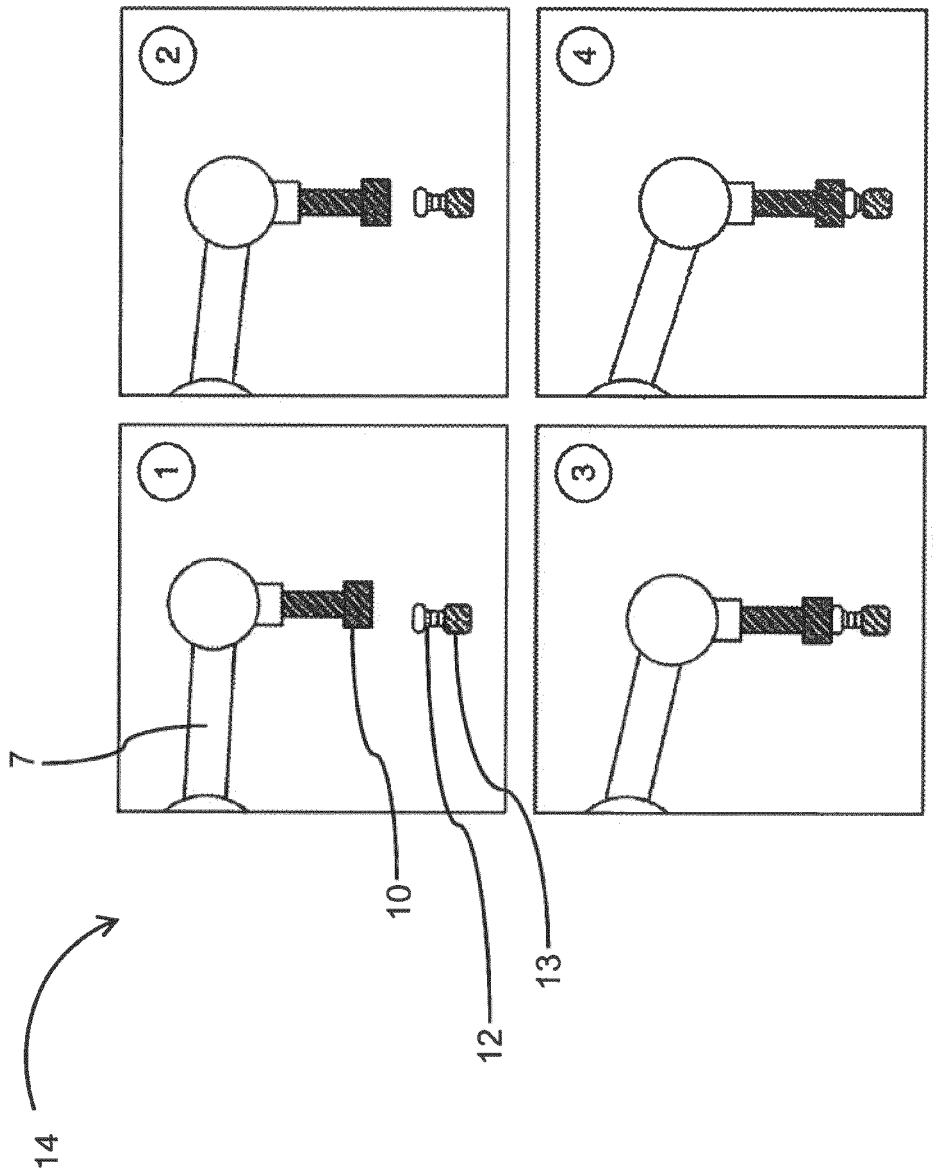

Fig. 13

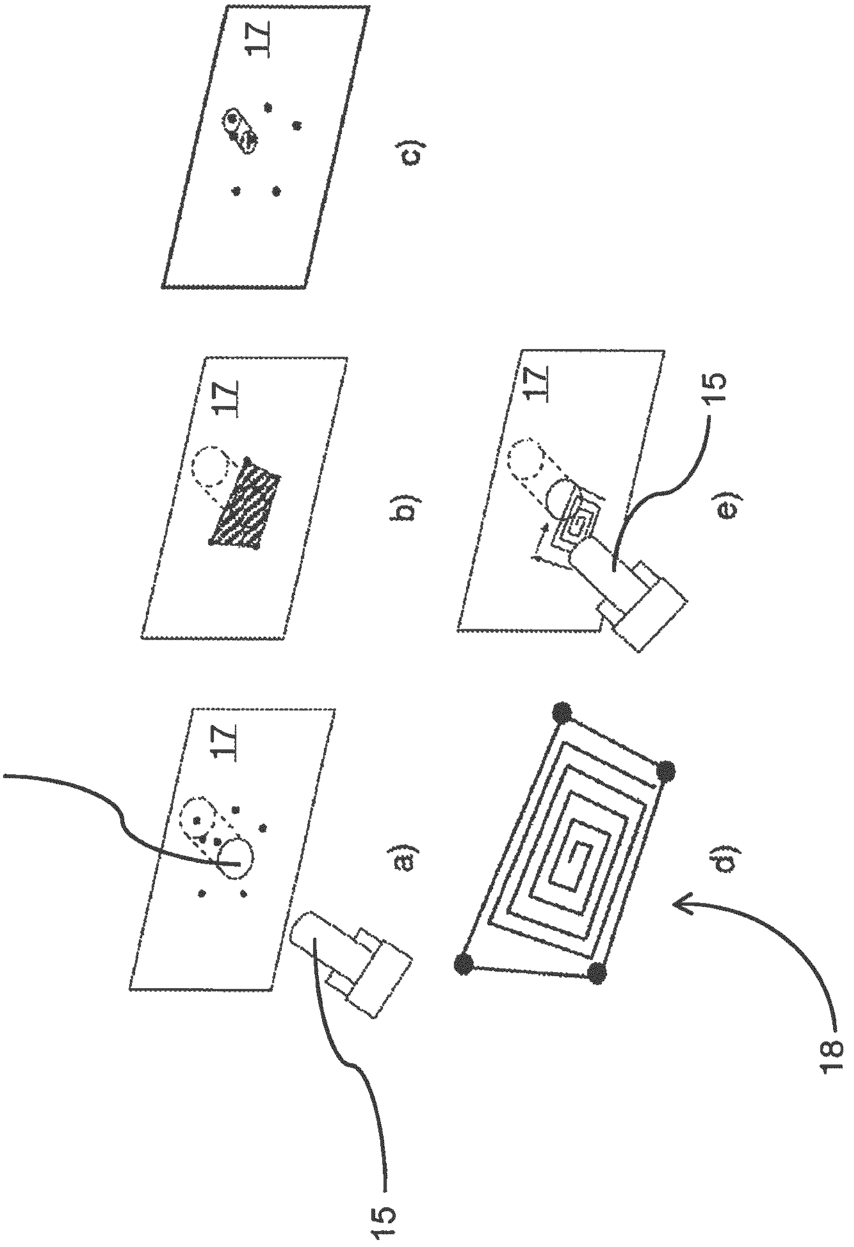

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Nicht-Patentliteratur


- **H. CHU et al.** INTEGRATION OF TASK PLANNING AND MOTION CONTROL IN A MULTI-ROBOT ASSEMBLY WORKCELL. *ROBOTICS AND COMPUTER INTEGRATED MANUFACTURING,* 01. Juni 1993, vol. 10, 235-255
- **BERENSON et al.** Manipulation Planning on Gonstraint Manifolds. *IEEE International Conference on Robotics and Automation (ICRA '09),* Mai 2009
- **STILMAN, M.** Task constrained motion planning in robot joint space. *Intelligent Robots and Systems,* 2007